# EUROPÄISCHE PATENTANMELDUNG

(11) **EP 4 757 093 A1**
(43) Veröffentlichungstag der Anmeldung: **10.06.2026**
(21) Anmeldenummer: 24218192.3
(22) Anmeldetag: 06.12.2024
(51) Int. Cl.: H02H 7/26, G01R 31/08

(54) **FEHLERERKENNUNGSANORDNUNG FÜR EIN ELEKTRISCHES GLEICHSPANNUNGSNETZWERK UND VERFAHREN ZUR FEHLERERKENNUNG IN EINEM ELEKTRISCHEM GLEICHSPANNUNGSNETZWERK**

(71) Anmelder: Fraunhofer-Gesellschaft zur Förderung der angewandten Forschung e.V., 80686 München (DE); Friedrich-Alexander-Universität Erlangen-Nürnberg, in Vertretung des Freistaates Bayern, 91054 Erlangen (DE)
(72) Erfinder: KUHN, Leonard, 91058 Erlangen (DE); BENTHEIMER, Christian, 91058 Erlangen (DE); HILPERT, Florian, 91058 Erlangen (DE); MÄRZ, Martin, 90491 Nürnberg (DE); MEINDL, Markus, 91054 Erlangen (DE)
(74) Vertreter: Hersina, Günter

(57) **Zusammenfassung**

Eine Fehlererkennungsanordnung (100) für ein elektrisches Gleichspannungsnetzwerk (205), das ein erstes und ein zweites Teilsystem (210, 220) aufweist, umfasst eine Mehrzahl von Sensorelementen (112 - 118, 122 - 128) zum Bereitstellen einer Mehrzahl von Sensorsignalen (S₁₁₂-S₁₁₈ und S₁₂₂-S₁₂₈), wobei die Sensorsignale zumindest ein erstes Stromsensorsignal (S₁₁₂) basierend auf einem Eingangsstrom (S₂₁₀) des ersten Teilsystems (210), ein erstes Spannungssensorsignal (S₁₁₄) basierend auf einer Eingangsspannung (S₂₁₂) des ersten Teilsystems (210), ein zweites Stromsensorsignal (S₁₂₂) basierend auf einem Eingangsstrom (S₂₂₀) des zweiten Teilsystems (220) und ein zweites Spannungssensorsignal (S₁₂₄) basierend auf einer Eingangsspannung (S₂₂₂) des zweiten Teilsystems (220) aufweisen, und
wobei die Fehlererkennungsanordnung (100) ausgebildet ist, um ein erstes Fehlererkennungssignal (F1) auszugeben, das einen elektrischen Fehlerzustand in dem ersten Teilsystem (210) angibt, falls das erste Stromsensorsignal (S₁₁₂) einen ersten oberen Fehlerstromgrenzwert überschreitet und falls ferner (zumindest) eine der folgenden Bedingungen erfüllt ist: das erste Spannungssensorsignal (S₁₁₄) unterschreitet einen ersten Spannungsgrenzwert, oder der Gradient des ersten Spannungssensorsignals (S₁₁₄) unterschreitet einen ersten negativen Gradienten-Grenzwert, und
wobei die Fehlererkennungsanordnung (100) ferner ausgebildet ist, um ein zweites Fehlererkennungssignal (F2) auszugeben, das einen elektrischen Fehlerzustand in dem zweiten Teilsystem (220) angibt, falls das zweite Stromsensorsignal (S₁₂₂) einen zweiten oberen Fehlerstromgrenzwert überschreitet und falls ferner eine der folgenden Bedingungen erfüllt ist: das zweite Spannungssensorsignal (S₁₂₄) unterschreitet einen zweiten Spannungsgrenzwert, oder der Gradient des zweiten Spannungssensorsignals (S₁₂₄) unterschreitet einen zweiten negativen Gradienten-Grenzwert.

## Beschreibung

### Technisches Gebiet

Die vorliegende Erfindung bezieht sich auf eine Fehlererkennungsanordnung (Fehlererkennungseinheit) für ein elektrisches Gleichspannungsnetzwerk, wie zum Beispiel einen elektrischen Antriebsstrang für einen mehrphasigen Elektromotor mit mehreren voneinander isolierten Teilsystemen oder eine Verteilerbox innerhalb eines Gleichspannungsnetzes. Die vorliegende Erfindung bezieht sich ferner auf ein Verfahren zur Fehlererkennung in einem elektrischen Gleichspannungsnetzwerk.

### Technischer Hintergrund

Auf dem Gebiet der Überwachung von elektrischen Gleichspannungsnetzwerken (DC-Netzen) ist eine hohe Zuverlässigkeit und Verfügbarkeit dieser elektrischen Gleichspannungsnetzwerke eine Grundvoraussetzung für deren praktische Anwendbarkeit. Dies gilt insbesondere für komplexe Antriebsstrangstrukturen für Elektroantriebe bzw. Elektromotoren. Mögliche Fehler im elektrischen Netzwerk (Netz), zu denen auch Fehler in Elektromotoren oder Invertern gehören, können zu einer Beeinträchtigung oder sogar zu einem Ausfall des gesamten Systems führen. Die zuverlässige Erkennung von Fehlern bzw. Fehlzuständen in dem System ist daher eine grundlegende Voraussetzung für den sicheren und zuverlässigen Betrieb von elektrischen Netzwerken, um deren hohe Verfügbarkeit zu gewährleisten.

Im Stand der Technik existieren bereits Ansätze zur Durchführung von Fehlerdiagnosen und zur Erkennung ausgewählter Fehler. Eine dieser Verfahren bzw. Vorgehensweisen ist eine modellbasierte Herangehensweise. Hierbei wird das Verhalten des Systems bzw. der Maschine modelliert und mit dem tatsächlichen (ermittelten bzw. gemessenen) Verhalten verglichen. Dabei werden Abweichungen identifiziert und Rückschlüsse auf mögliche Fehler abgeleitet. Im Vergleich dazu ermöglicht eine signalbasierte Vorgehensweise eine Fehlerdiagnose anhand der gemessenen Signale, ohne dass ein spezifisches Maschinenmodell erforderlich ist. Als eine weitere Vorgehensweise nutzt eine wissensbasierte Methode maschinelles Lernen, um Fehler zu diagnostizieren, wobei das mathematische Modell der Maschine, zum Beispiel einer Permanentmagnetmaschine, dabei nicht zwingend notwendig ist. Bei einer weiteren Vorgehensweise wird eine hybride Methode genutzt, bei der zwei oder mehr unterschiedliche Diagnoseansätze kombiniert werden, um beispielsweise jeweilige unterschiedliche Ergebnisse der einzelnen Methoden zu nutzen.

Hinsichtlich beispielhafter Patentveröffentlichungen und wissenschaftlicher Veröffentlichungen von Ansätzen zur Durchführung von Fehlerdiagnosen und zur Erkennung ausgewählter Fehler wird auf das beispielhafte Literaturverzeichnis am Ende der Beschreibung verwiesen.

Die der vorliegenden Erfindung zu Grunde liegende Aufgabe besteht daher darin, eine verbesserte Fehlererkennungsanordnung und ein verbessertes Verfahren zur Fehlererkennung für ein elektrisches Gleichspannungsnetzwerk zu schaffen. Dabei soll eine zuverlässige und korrekte Erkennung von fehlerhaften Zuständen in dem elektrischen Gleichspannungsnetzwerk ermöglicht werden, wobei zu deren Umsetzung möglichst geringfügige oder keine strukturellen Veränderungen an dem bestehenden System, d.h. dem elektrischen Gleichspannungsnetzwerk, erforderlich sein sollten.

Diese Aufgabe wird durch den Gegenstand der unabhängigen Patentansprüche 1 und 16 gelöst.

Spezifische Ausgestaltungen, Implementierungen und Weiterbildungen der vorliegenden Erfindung sind in den abhängigen Patentansprüchen definiert.

### Überblick über das erfindungsgemäße Konzept

Gemäß einem Ausführungsbeispiel umfasst die erfindungsgemäße Fehlererkennungsanordnung für ein elektrisches Gleichspannungsnetzwerk, das (zumindest) ein erstes und ein zweites Teilsystem aufweist, eine Mehrzahl von Sensorelementen zum Bereitstellen einer Mehrzahl von Sensorsignalen, wobei die Sensorsignale zumindest ein erstes Stromsensorsignal basierend auf einem Eingangsstrom des ersten Teilsystems, ein erstes Spannungssensorsignal basierend auf einer Eingangsspannung des ersten Teilsystems, ein zweites Stromsensorsignal basierend auf einem Eingangsstrom des zweiten Teilsystems und ein zweites Spannungssensorsignal basierend auf einer Eingangsspannung des zweiten Teilsystems aufweisen. Die Fehlererkennungsanordnung ist ausgebildet, um ein erstes Fehlererkennungssignal auszugeben, das einen elektrischen Fehlerzustand in dem ersten Teilsystem angibt, falls das erste Stromsensorsignal einen ersten oberen Fehlerstromgrenzwert überschreitet und falls ferner (zumindest) eine der folgenden Bedingungen erfüllt ist: (-) das erste Spannungssensorsignal unterschreitet einen ersten Spannungsgrenzwert, oder (-) der Gradient des ersten Spannungssensorsignals unterschreitet einen ersten negativen Gradienten-Grenzwert (einen ersten negativen Grenzwert der Spannungsänderungsgeschwindigkeit (= zeitliche Ableitung dU/dt), und wobei die Fehlererkennungsanordnung ferner ausgebildet ist, um ein zweites Fehlererkennungssignal auszugeben, das einen elektrischen Fehlerzustand in dem zweiten Teilsystem angibt, falls das zweite Stromsensorsignal einen zweiten oberen Fehlerstromgrenzwert überschreitet und falls ferner (zumindest) eine der folgenden Bedingungen erfüllt ist: (-) das zweite Spannungssensorsignal unterschreitet einen zweiten Spannungsgrenzwert, oder (-) der Gradient des zweiten Spannungssensorsignals unterschreitet einen zweiten negativen Gradienten-Grenzwert (eine zweiten negativen Grenzwert der Spannungsänderungsgeschwindigkeit (zeitliche Ableitung dU/dt).

Gemäß einem Ausführungsbeispiel umfasst das erfindungsgemäße Verfahren zur Fehlererkennung in einem elektrischem Gleichspannungsnetzwerk, das (zumindest) ein erstes und ein zweites Teilsystem aufweist, folgende Schritte:
Bereitstellen einer Mehrzahl von Sensorsignalen (von einer Mehrzahl von Sensorelementen), wobei die Sensorsignale zumindest ein erstes Stromsensorsignal basierend auf einem Eingangsstrom des ersten Teilsystems, ein erstes Spannungssensorsignal basierend auf einer Eingangsspannung des ersten Teilsystems, ein zweites Stromsensorsignal basierend auf einem Eingangsstrom des zweiten Teilsystems und ein zweites Spannungssensorsignal basierend auf einer Eingangsspannung des zweiten Teilsystems aufweisen,
Ausgeben eines ersten Fehlererkennungssignals, das einen elektrischen Fehlerzustand in dem ersten Teilsystem angibt, falls das erste Stromsensorsignal einen ersten oberen Fehlerstromgrenzwert überschreitet und falls ferner (zumindest) eine der folgenden Bedingungen erfüllt ist:
   - das erste Spannungssensorsignal unterschreitet einen ersten Spannungsgrenzwert, oder
   - der Gradient des ersten Spannungssensorsignals unterschreitet einen ersten negativen Gradienten-Grenzwert [negativer Grenzwert der Spannungsänderungsgeschwindigkeit (zeitliche Ableitung dU/dt)], und
Ausgeben eines zweiten Fehlererkennungssignals, das einen elektrischen Fehlerzustand in dem zweiten Teilsystem angibt, falls das zweite Stromsensorsignal einen zweiten oberen Fehlerstromgrenzwert überschreitet und falls ferner (zumindest) eine der folgenden Bedingungen erfüllt ist:
- das zweite Spannungssensorsignal unterschreitet einen zweiten Spannungsgrenzwert, oder
- der Gradient des zweiten Spannungssensorsignals unterschreitet einen zweiten negativen Gradienten-Grenzwert [negativer Grenzwert der Spannungsänderungsgeschwindigkeit (zeitliche Ableitung dU/dt)].

Die obige Strom-/Spannungsbeziehung bei der Erfassung eines Fehlerzustands in dem ersten und/oder zweiten Teilsystem des elektrisches Gleichspannungsnetzwerks ermöglicht eine Unterscheidung zwischen Ausgleichsströmen und Fehlerströmen in den Teilsystemen. Liegt ein Fehler in einem der Teilsysteme vor, sinkt die Spannung (Zwischenkreisspannung) bei einem erhöhten Eingangsstrom (Fehlerstrom) in dem betroffenen Teilsystem. In einem fehlerfreien Teilsystem sinkt die Spannung (Zwischenkreisspannung) bei einem negativen oder verringerten Eingangsstrom (Fehlerstrom). Die obige Strom-/Spannungsbeziehung gibt somit Bedingungen zur Erkennung eines Fehlerzustands in einem der Teilsysteme an.

Die Erkennung und die Differenzierung zwischen Fehlerströmen und Ausgleichsströmen in dem elektrischen Gleichspannungsnetz ist also durch die (zeitsynchrone) Auswertung von Strom und Spannung möglich. Durch das Verwenden von mindestens zwei Fehlerkriterien zur Erkennung eines Fehlers wird ein Höchstmaß an Zuverlässigkeit und Robustheit erreicht. Die Fehlererkennungseinheit ist aufgrund der strukturellen Implementierung vollständig in Hardware realisierbar, wodurch eine Zertifizierung der Fehlererkennungseinheit für sicherheitskritische Anwendungen vereinfacht wird.

Mit der erfindungsgemäßen Fehlererkennungsanordnung können Fehlermanagementmaßnahmen innerhalb des elektrischen Netzes ergriffen werden, wobei diese Maßnahmen auf der zulässigen und korrekten Erkennung von fehlerhaften Zuständen bzw. Betriebszuständen in dem elektrischen Gleichspannungsnetz beruhen. Somit kann das elektrische Gleichspannungsnetzwerk durch das Erkennen von Fehlern bzw. Fehlerzuständen geschützt werden, um dessen Betrieb zuverlässig sicherzustellen. Dadurch kann die Zuverlässigkeit und die Verfügbarkeit des elektrischen Gleichspannungsnetzwerkes bzw. des gesamten Systems erhöht werden. Ferner kann durch die erfindungsgemäße Fehlererkennungsanordnung eine Differenzierung erfolgen, ob der jeweilige Fehlerzustand innerhalb oder außerhalb des von der Fehlererkennungsanordnung (Erkennungseinheit) zu schützenden Bereichs liegt. Basierend auf der (örtlichen) Differenzierung und der Erkennung von sicherheitsrelevanten Fehlern kann das System zum Beispiel durch die gezielte Abtrennung fehlerhafter Teilsysteme des elektrischen Gleichspannungsnetzwerks von dem Gesamtsystem korrekt reagieren.

Ferner kann durch die Fehlererkennungsanordnung die Struktur des elektrischen Netzwerkes als wesentlicher Einflussfaktor für die korrekte Erkennung von Fehlerzuständen berücksichtigt werden, wobei das elektrische Gleichspannungsnetzwerk eine oder mehrere Energiequellen und eine oder mehrere Lasten aufweisen kann. Ferner können unterschiedliche Formen an Energiespeichern innerhalb eines solchen Gleichspannungsnetzwerks vorhanden sein. Ferner kann die erfindungsgemäße Fehlererkennungsanordnung bei (immer mehr aufkommenden) mehrphasigen elektrischen Motoren bzw. Maschinen eingesetzt werden. Die bestehenden Wechselwirkungen in solchen mehrphasigen Maschinen führen zu komplexeren und veränderten Fehlerszenarien sowie Fehlerverhalten, die mit der erfindungsgemäßen Fehlererkennungsanordnung erfasst werden können. So wäre eine Überstromerkennung alleine nicht in der Lage, alle Fehlerszenarien zuverlässig und korrekt zu erkennen. Die erfindungsgemäße Fehlererkennungsanordnung kann aber solche (ansonsten nicht erkannten) Szenarien zuverlässig und korrekt erkennen, so dass fälschlich erkannte Fehlerzustände durch die erfindungsgemäße Fehlererkennungsanordnung vermieden werden können.

Mit der erfindungsgemäßen Fehlererkennungsanordnung können somit falsch Positiv- oder falsch Negativ-Erkennungen von Fehlerzuständen und damit negative (und möglicherweise verheerende) Auswirkungen für das System, d.h. das elektrische Gleichspannungsnetzwerk, zuverlässig und sicher vermieden werden. Die erfindungsgemäße Fehlererkennungsanordnung ermöglicht somit eine robuste und zuverlässige Fehlererkennung in einem elektrischen Gleichspannungsnetzwerk basierend auf der Auswertung und Kombination von unterschiedlichen Fehlerkriterien basierend auf den von den Sensorelementen bereitgestellten unterschiedlichen Strom- und Spannungssensorsignalen.

Die erfindungsgemäße Fehlererkennungsanordnung schafft somit einen Lösungsansatz, bei dem keine oder im Wesentlichen keine zusätzliche Hardware in dem zu überwachenden elektrischen Gleichspannungsnetzwerk oder dem Gesamtsystem, z. B. in der Last (dem Elektromotor), dem Zwischenkreis, der Energiequelle oder in anderen Elementen des Netzwerks, erforderlich ist. Somit kann die erfindungsgemäße Fehlererkennungsanordnung eine Fehlererkennung realisieren, ohne dass strukturelle Veränderungen an dem bestehenden System erforderlich sind.

Die erfindungsgemäße Fehlererkennungsanordnung ist somit gegenüber Systemen, welche im Frequenz- oder Zeit-Frequenz-Bereich arbeiten, aufgrund des verringerten Rechenaufwands als eine reine (z.B. analoge) Hardwarelösung realisierbar. Daher kann die erfindungsgemäße Fehlererkennungsanordnung als eine analoge Signalauswerteschaltung ausgebildet werden, die im Zeitbereich arbeiten kann, um die die Fehlererkennung durchzuführen. Gemäß einem Ausführungsbeispiel kann die Fehlererkennungsanordnung ausschließlich analoge Logikelemente zur analogen Signalauswertung aufweisen.

Die erfindungsgemäße Fehlererkennungsanordnung kann somit das zu überwachende elektrische Gleichspannungsnetzwerk, z.B. einen Gleichspannungszwischenkreis mit Wechselrichter (Inverter), zuverlässig schützen, da ein fehlerhaftes Teilsystem innerhalb des Gleichspannungsnetzwerks von der erfindungsgemäßen Fehlererkennungsanordnung zuverlässig und schnell erkannt und dann von dem Gesamtsystem elektrisch getrennt werden kann.

Diese Information, die beispielsweise durch die Ausgabe eines dem Fehler zugeordneten Fehlersignals vorliegt, kann nun von einem entsprechenden Fehlermanagementsystem genutzt werden, um den Betrieb anderer fehlerfreier Teilsysteme sicherzustellen, indem z.B. das fehlerhafte Teilsystem von dem Gesamtsystem elektrisch getrennt werden. Dabei ist es gemäß der erfindungsgemäßen Fehlererkennungsanordnung nicht von entscheidender Bedeutung, die Fehlerart oder Fehlerposition im Einzelnen zu identifizieren, da der Fokus der erfindungsgemäßen Fehlererkennungsanordnung viel mehr auf der Erkennung von Fehlern bzw. Fehlerzuständen der einzelnen Teilsysteme liegt, die erhebliche Auswirkungen auf das zu überwachende elektrische Gleichspannungsnetzwerk haben. Gemäß einem Ausführungsbeispiel der erfindungsgemäßen Fehlererkennungsanordnung kann es beispielsweise ausreichend sein, lediglich ausgewählte Fehler zu erkennen, welche negative Auswirkungen auf das Gesamtsystem bzw. dessen Funktionsweise und Betrieb hervorrufen. Entsprechend der erfindungsgemäßen Vorgehensweise ist beispielsweise eine weitergehende Differenzierung nicht erforderlich.

Entsprechend der erfindungsgemäßen Vorgehensweise werden beispielsweise die einzelnen Teilsysteme der DC-Netzes geschützt und bei einem Fehlerzustand von dem Gesamtsystem getrennt, wodurch ein Weiterbetrieb des Hochspannungsnetzes bzw. weiterer Teilsysteme ermöglicht wird. Damit werden nicht nur Fehler im überwachten Teilsystem erkannt, sondern auch Fehler in benachbarten Teilsystemen von der Erkennung ausgeschlossen. Die erfindungsgemäßen Vorgehensweise ermöglicht eine schnelle Fehlererkennung und Reaktion auf eine Fehlerzustand, da beispielsweise analoge Sensorsignale verarbeitet werden, wobei auch die schnelle Verarbeitung digitaler Sensorsignale möglich ist.

In der nachfolgenden Beschreibung werden noch unterschiedliche Ausführungs- und Anwendungsbeispiele für die erfindungsgemäße Fehlererkennungsanordnung für ein elektrisches Gleichspannungsnetzwerk sowie für das erfindungsgemäße Verfahren zur Fehlererkennung im Detail dargestellt.

### Kurzbeschreibung der Zeichnungen und Figuren:

Bevorzugte Ausführungsbeispiele der vorliegenden Erfindung werden nachfolgend unter Bezugnahme auf die beiliegenden Zeichnungen und Figuren näher erläutert. Es zeigen:
- Fig. 1: ein schematisches Schaltungsdiagramm eines elektrischen Netzwerks, das ein elektrisches Gleichspannungsnetzwerk und eine Fehlererkennungsanordnung für das elektrische Gleichspannungsnetzwerk gemäß einem Ausführungsbeispiel aufweist;
- Fig. 2a-b: ein schematisches Schaltungsdiagramm des zu überwachenden elektrischen Gleichspannungsnetzwerks während eines zu erfassenden Fehlerzustands gemäß einem Ausführungsbeispiel;
- Fig. 3a-b: graphische Darstellungen und Verläufe von Messgrößen in Form von erfassten Stromsensorsignalen und Spannungssensorsignalen eines fehlerhaften Teilsystems und eines fehlerfreien Teilsystems des zu überwachenden elektrischen Gleichspannungsnetzwerks;
- Fig. 4: ein schematisches Schaltungsdiagramm eines elektrischen Netzwerks, das ein zu überwachendes elektrisches Gleichspannungsnetzwerk mit der Fehlererkennungsanordnung gemäß einem weiteren Ausführungsbeispiel aufweist;
- Fig. 5: ein schematisches funktionales Blockdiagramm einer erfindungsgemäßen Fehlererkennungsanordnung gemäß einem weiteren Ausführungsbeispiel;
- Fig. 6: ein schematisches funktionale Blockdiagramm einer erfindungsgemäßen Fehlererkennungsanordnung gemäß einem weiteren Ausführungsbeispiel; und
- Fig. 7: ein schematisches Diagramm des erfindungsgemäßen Verfahrens zur Fehlererkennung in einem zu überwachenden elektrischen Gleichspannungsnetzwerk gemäß einem Ausführungsbeispiel.

Bevor nachfolgend Ausführungsbeispiele der vorliegenden Erfindung im Detail anhand der Zeichnungen näher erläutert werden, wird darauf hingewiesen, dass identische, funktionsgleiche oder gleichwirkende Elemente, Objekte, Funktionsblöcke und/oder Verfahrensschritte in den unterschiedlichen Figuren mit den gleichen Bezugszeichen versehen sind, so dass die in unterschiedlichen Ausführungsbeispielen dargestellte Beschreibung dieser Elemente, Objekte, Funktionsblöcke und/oder Verfahrensschritte (mit gleichen Bezugszeichen) untereinander austauschbar ist bzw. aufeinander angewendet werden kann.

### Detaillierte Beschreibung der Figuren und Ausführungsbeispiele

Es versteht sich, dass, wenn ein Element als mit einem anderen Element elektrisch "verbunden" oder "gekoppelt" bezeichnet wird, es direkt mit dem anderen Element elektrisch verbunden oder gekoppelt sein kann oder Zwischenelemente vorhanden sein können. Wenn im Gegensatz ein Element als "direkt" mit einem anderen Element "verbunden" oder "gekoppelt" bezeichnet wird, sind keine Zwischenelemente vorhanden. Sonstige zum Beschreiben des Verhältnisses zwischen Elementen benutzten Ausdrücke sollten auf gleichartige Weise ausgelegt werden (z.B. "zwischen" gegenüber "direkt zwischen", "benachbart" gegenüber "direkt benachbart" usw.). In den Figuren sind die unterschiedlichen Elemente nicht maßstäblich sondern nur schematisch dargestellt.

Im Rahmen der vorliegenden Beschreibung ist ein in Klammern gesetzter Begriff und/oder eine Textpassage als eine weitere alternative Bezeichnung oder beispielhafte Erläuterung, Ausgestaltung, Ergänzung bzw. Alternative zu dem voranstehenden Begriff oder der voranstehenden Textpassage zu verstehen.

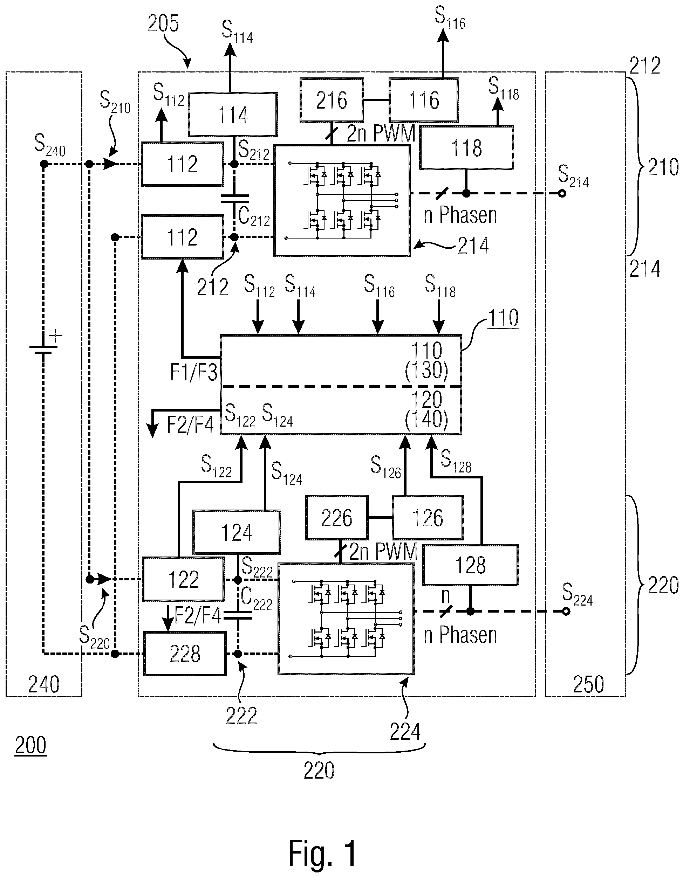

Fig. 1 zeigt nun ein schematisches Schaltungsdiagramm eines elektrischen Netzwerks (Gesamtsystems) 200, das ein elektrisches Gleichspannungsnetzwerk 205 und eine Fehlererkennungsanordnung 100 für das elektrische Gleichspannungsnetzwerk 205 gemäß einem Ausführungsbeispiel aufweist. Das elektrische Gleichspannungsnetzwerk 205 weist (zumindest) ein erstes und ein zweites Teilsystem 210, 220 auf. Die Fehlererkennungsanordnung 100 weist nun ferner eine Mehrzahl von Sensorelementen 112, 114, 116, 118 und 122, 124, 126, 128 auf, um eine Mehrzahl von Sensorsignalen S₁₁₂-S₁₁₈ und S₁₂₂-S₁₂₈ bereitzustellen. Dabei weisen die Sensorsignale zumindest ein erstes Stromsensorsignal S₁₁₂ basierend auf einem Eingangsstrom S₂₁₆ des ersten Teilsystems 210, ein erstes Spannungssensorsignal S₁₁₄ basierend auf einer Eingangsspannung S₂₁₂ des ersten Teilsystems 210, ein zweites Stromsensorsignal S₁₂₂ basierend auf einem Eingangsstrom S₂₂₀ des zweiten Teilsystems 220 und ein zweites Spannungssensorsignal S₁₂₄ basierend auf einer Eingangsspannung S₂₂₂ des zweiten Teilsystems 120 auf.

Die Fehlererkennungsanordnung 100 ist nun ausgebildet, um ein erstes Fehlererkennungssignal F1 (Trigger-Signal oder Auslösesignal) auszugeben, das einen elektrischen Fehlerzustand in dem ersten Teilsystem 210 angibt, falls das erste Stromsensorsignal S₁₁₂ einen ersten oberen Fehlerstromgrenzwert überschreitet und falls ferner (zumindest) eine der folgenden Bedingungen erfüllt ist: Das erste Spannungssensorsignal S₁₁₄ unterschreitet einen ersten Spannungssensorgrenzwert oder der Gradient des ersten Spannungssensorsignals S₁₁₄ unterschreitet einen ersten negativen Gradienten-Grenzwert, d.h. einen negativen Grenzwert der Spannungsänderungsgeschwindigkeit (zeitlich Ableitung dU/dt).

Der jeweilig angegebene Grenzwert für den Vergleich mit einem erfassten bzw. erfassten und aufbereiteten Sensorsignal wird i.A. abhängig von der tatsächlichen technischen Implementierung des elektrischen Netzwerks 200 und den darin verwendeten Komponenten ermittelt. Dazu können auch Simulationsergebnisse von maximal zulässigen Werten (Amplituden, Zeitdauern, Gradienten etc.) der Strom- und Spannungssensorsignale in dem elektrischen Netzwerk 200 und dessen Komponenten herangezogen werden.

Hinsichtlich der (oberen oder unteren) Fehlerstromgrenzwerte zum Beurteilen des ersten und zweiten Stromsensorsignals wird ferner darauf hingewiesen, dass der erste und zweite Fehlerstromgrenzwert (und bei weiteren Teilsystemen die weiteren Fehlerstromgrenzwerte) bei gleich ausgebildeten Teilsystemen gleich sein können, oder bei unterschiedlich ausgebildeten Teilsystemen auch unterschiedlich sein können. Dies gilt auch für die anderen Grenzwerte, wie z.B. Spannungsgrenzwerte, Gradienten-Grenzwerte oder (obere bzw. untere) Phasenfehlerstromgrenzwerte.

Dabei sind die Grenzwerte sehr stark abhängig von den Systeminduktivitäten, Leitungswiderständen, Kurzschlusswiderständen, vom Batterie- oder Quellwiderstand etc., welche vom Gesamtsystem 200, z.B. einem elektrischen Antriebsstrang, definiert werden.

Die Fehlererkennungsanordnung 100 ist nun ferner ausgebildet, um ein zweites Fehlererkennungssignal F2 auszugeben, das einen elektrischen Fehlerzustand in dem zweiten Teilsystem 220 angibt, falls das zweite Stromsensorsignal S₁₂₂ einen zweiten oberen Fehlerstromwert überschreitet und falls ferner (zumindest) eine der folgenden Bedingungen erfüllt ist: Das zweite Spannungssensorsignal S₁₂₄ unterschreitet einen zweiten Spannungsgrenzwert, oder der Gradient des zweiten Spannungssensorsignals S₁₂₄ unterschreitet einen zweiten negativen Gradienten-Grenzwert, d.h. einen negativen Grenzwert der Spannungsänderungsgeschwindigkeit (zeitliche Ableitung dU/dt).

Gemäß einem Ausführungsbeispiel kann das erste Teilsystem 210 des elektrischen Gleichspannungsnetzwerks 205 einen ersten elektrischen Gleichspannungszwischenkreis 212 und das zweite Teilsystem 220 des elektrischen Gleichspannungsnetzwerks 205 einen zweiten elektrischen Gleichspannungszwischenkreis 222 aufweisen. Ferner kann das erste Teilsystem 210 des elektrischen Gleichspannungsnetzwerks einen ersten (z.B. mehrphasigen bzw. n-phasigen) Wechselrichter 214 und das zweite Teilsystem 220 des elektrischen Gleichspannungsnetzwerks 200 einen zweiten (z.B. mehrphasigen bzw. n-phasigen) Wechselrichter 224 aufweisen bzw. damit verbunden sein.

Gemäß einem Ausführungsbeispiel kann somit das erste Stromsensorsignal S₁₁₂ auf einem Eingangsgleichstrom S₂₁₆ des ersten (mehrphasigen) Wechselrichters 214 basieren, wobei das zweite Stromsensorsignal S₁₂₂ auf einem Eingangsgleichstrom des zweiten (mehrphasigen) Wechselrichters 224 basieren kann. Ferner kann das erste Spannungssensorsignal S₁₁₄ auf einer Zwischenkreisspannung S₂₁₂ am Eingang des ersten (mehrphasigen) Wechselrichters 214 und das zweite Spannungssensorsignal S₁₂₄ auf einer Zwischenkreisspannung S₂₂₂ am Eingang des zweiten (mehrphasigen) Wechselrichters 224 basieren.

Wie in dem schematischen Schaltungsdiagramm von Fig. 1 ferner beispielhaft dargestellt ist, kann das elektrische Netzwerk 200 eine oder mehrere Energiequellen 240 zum Bereitstellen der Strom- und Spannungssignale an das erste und zweite Teilsystem 210, 220 des elektrischen Gleichspannungsnetzwerks 205 aufweisen. Die Energiequelle 240 kann als eine (einzelne) Energiequelle oder als eine Mehrzahl von (zumindest zwei) Energiequellen zum Versorgen der Teilsysteme 210, 220 vorgesehen sein. Beispielsweise kann die Energiequelle 240 mit einem elektrischen Netz (Strom- oder Spannungsnetz) verbunden sein, wobei dann Gleichrichter der Energiequelle 240 die Eingangsströme und Eingangsspannungen (als Gleichsignale S₂₁₀, S₂₂₀) für die Teilsysteme 210, 220 bereitstellen. Die Energiequelle 240 kann ferner als Energiespeicher bzw. Batterie ausgebildet sein, bzw. eine Mehrzahl von Energiespeichern und Batterien aufweisen, um die Eingangsströme und Eingangsspannungen (als Gleichsignale S₂₁₀, S₂₂₀) für die Teilsysteme 210, 220 bereitzustellen.

Der elektrische Zwischenkreis 212 des ersten Teilsystems 210 und der elektrische Zwischenkreis 222 des zweiten Teilsystems 220 sind also eingangsseitig mit einer Energiequelle bzw. mehreren Energiequellen 240 verbunden, die ein Gleichsignal S₂₁₀, S₂₂₀ bereitstellt, und sind ausgangsseitig beispielsweise jeweils mit einem (z.B. mehrphasigen) Wechselrichter (Inverter oder Drehrichter) 214, 224 verbunden, der die von dem elektrischen Zwischenkreis 212, 222 bereitgestellte Gleichspannung S₂₁₂, S₂₂₂ in eine Wechselspannung bzw. ein mehrphasiges Wechselsignal S₂₁₄, S₂₂₄ umwandelt. Das ausgangsseitige (z.B. mehrphasige) Wechselsignal S₂₁₄, S₂₂₄ des Wechselrichters 214, 224 jedes Teilsystems 210, 220 kann nun an eine Last 250, wie z. B. einem elektrischen Antrieb oder Elektromotor, bereitgestellt werden. Die Last 250 kann nun beispielsweise als ein einzelnes Lastelement oder eine Mehrzahl von Lastelementen ausgebildet sein.

Wie in dem Schaltungsdiagramm von Fig. 1 beispielhaft dargestellt ist, werden von den Wechselrichtern 214, 224 das mehrphasige (n-phasige) Wechselsignal S₂₁₄, S₂₂₄ an die Last 250 bereitgestellt. Ferner sind beispielsweise eine erste Treiberschaltungsanordnung (Gate-Driver) 216 zur Ansteuern des ersten mehrphasigen Wechselrichters 214 und eine zweite Treiberschaltungsanordnung (Gate-Driver) 226 zur Ansteuern des zweiten mehrphasigen Wechselrichters 224 vorgesehen. Das Ansteuern der Wechselrichter 214, 224 kann beispielsweise mit 2n PWM-Signalen (PWM = Pulsweitenmodulation), d.h. mit zwei PWM-Signalen pro Phase der Wechselrichter 214, 224, erfolgen. Als PWM-Wechselrichter (Pulsweitenmodulation) werden allgemein Leistungselektronikgeräte, die ein Gleichsignal S₂₁₀, S₂₂₆ (Gleichstrom) mithilfe von Pulsweitenmodulationstechniken in ein Wechselsignal S₂₁₄, S₂₂₄ (Wechselstrom) umwandeln.

Die Gleichspannungszwischenkreise 212, 222 weisen beispielsweise jeweils (zumindest) einen Zwischenkreiskondensator C₂₁₂, C₂₂₂ auf, der den eigentlichen Energiespeicher des Zwischenkreises 212, 222 bildet. Die Zwischenkreisspannung S₂₁₂, S₂₂₂ ist die im Zwischenkreis 212, 222 vorherrschende Spannung, die durch den stetigen Energie-Eingang und - Ausgang schwanken kann und über die anliegende Spannung S₂₄₀ der Energiequelle 240 jeweils angepasst zw. versorgt werden kann.

Gemäß einem Ausführungsbeispiel weist das elektrische Gleichspannungsnetzwerk 205 das erste und zweite Teilsystem 210, 220 auf. Die Ausführungsbeispiele der vorliegenden Erfindung sind aber gleichermaßen auf ein elektrisches Gleichspannungsnetzwerk mit weiteren Teilsystemen (230, ...) anwendbar, deren Strom- und Spannungssignale entsprechend dem oben dargestellten ersten und zweiten Teilsystem 210, 220 hinsichtlich eines Fehlerzustands ausgewertet und überwacht werden können, um dann ein entsprechendes weiteres Fehlererkennungssignal auszugeben, das einen elektrischen Fehlerzustand in einem weiteren Teilsystem angibt.

Wie in dem schematischen Schaltungsdiagramm von Fig. 1 ferner beispielhaft dargestellt ist, kann die Fehlererkennungsanordnung 100 als eine zentralen Signalauswerteschaltung in (als Teil von) oder an (extern zu) dem elektrischen Gleichspannungsnetzwerk 205 angeordnet sein, wobei die erfassten Sensorsignale S₁₁₂-S₁₁₈ und S₁₂₂-S₁₂₈ zentral verarbeitet werden können.

Gemäß einem weiteren Ausführungsbeispiel kann die erfindungsgemäße Fehlererkennungsanordnung 100 auch als eine modulare (örtlich getrennte) Anordnung ausgebildet sein, d.h., die Fehlererkennungsanordnung 100 weist für das erste und zweite Teilsystem 210, 220 und für etwaige weitere Teilsysteme jeweils eine eigene Fehlererkennungsvorrichtung (Signalauswerteschaltung) 110, 120 auf, die örtlich getrennt und unabhängig voneinander als modulare Umsetzung implementiert sein kann. Bei einer modularen Anordnung der ersten und zweiten Fehlererkennungsvorrichtung 110, 120 kann die erste Fehlererkennungsvorrichtung 110 beispielsweise in dem ersten Teilsystem 210 und die zweite Fehlererkennungsvorrichtung 120 in dem zweiten Teilsystem 210 angeordnet sein.

Die modulare Struktur der erfindungsgemäßen Fehlererkennungsanordnung 100 mit der ersten und zweiten Fehlererkennungsvorrichtung 110, 120 ergibt sich aufgrund der Unabhängigkeit von externen Signalen. Dies umfasst sämtliche Signale, welche nicht von dem zu schützendem Teilsystem 210, 220 generiert werden.

Gemäß einem Ausführungsbeispiel kann die Fehlererkennungsanordnung 100 also die erste und die zweite Fehlererkennungsvorrichtung 110, 120 (als eine erste und zweite Signalauswerteschaltung) aufweisen, wobei die erste Fehlererkennungsvorrichtung 110 dem ersten Teilsystem 210 und die zweite Fehlererkennungsvorrichtung 120 dem zweiten Teilsystem 220 zugeordnet ist. Die Sensorelemente 112, 114, 116, 118 und 122, 124, 126, 128 sind nun ausgebildet, um die Mehrzahl von Sensorsignalen S₁₁₂-S₁₁₈ und S₁₂₂-S₁₂₈ für die erste und die zweite Fehlererkennungsvorrichtung 110, 120 bereitzustellen.

Die erste Fehlererkennungsvorrichtung 110 ist nun beispielsweise ausgebildet, um das erste Fehlererkennungssignal F1 auszugeben, das einen elektrischen Fehlerzustand in dem ersten Teilsystem 210 angibt bzw. anzeigt, wobei die zweite Fehlererkennungsvorrichtung beispielsweise ausgebildet ist, um das zweite Fehlererkennungssignal F2 auszugeben, das einen elektrischen Fehlerzustand in dem zweiten Teilsystem 220 angibt.

Der zentralen oder modularen Ausgestaltung der erfindungsgemäßen Fehlererkennungsanordnung 100 ist nun technisch gesehen gemeinsam, dass eine individuelle Überwachung der einzelnen, unterschiedlichen Teilsysteme 210, 220, ... des elektrischen Gleichspannungsnetzwerks 210 erfolgt, ohne dass ein Informationsfluss bzw. Informationsaustausch zwischen diesen Teilsystemen erforderlich ist. Die Umsetzung der Fehlererkennungsanordnung 100 kann somit durch eine zentrale Anordnung der Fehlererkennungsanordnung 100 oder durch eine modulare Anordnung einer Mehrzahl von jeweils den einzelnen Teilsystemen 110, 220 zugeordneten Fehlererkennungsvorrichtungen 110, 120 realisiert werden.

Hinsichtlich der Sensorelemente 112, 114, 116, 118 und 122, 124, 126, 128 zum Bereitstellen der Mehrzahl von Sensorsignalen S₁₁₂-S₁₁₈ und S₁₂₂-S₁₂₈ wird darauf hingewiesen, dass gemäß einem Ausführungsbeispiel beispielsweise jedes Teilsystem ein eigenes Stromsensorelement 112, 122 aufweist. Gemäß einem Ausführungsbeispiel kann je nach Aufbau des elektrischen Gleichspannungsnetzwerks 205 bzw. dessen Teilsystemen 210, 220 das erste und zweite Spannungssensorsignal S₁₁₂, S₁₂₂ des ersten und zweiten Teilsystems 210, 220 (oder auch weitere Spannungssensorsignale weiterer Teilsysteme) von einem gemeinsamen Spannungssensor 114 oder 124 kommen, falls aufgrund des Aufbaus der Energiequelle 240 sowie des Anschlusses des ersten und zweiten Teilsystems 210, 220 bzw. der weiteren Teilsysteme an die Energiequelle 240 von einer gleichmäßigen Versorgungsspannung S₂₄₀ (und damit einer gemeinsamen Zwischenkreisspannung) an allen Teilsystemen 210, 220 ausgegangen werden kann. Alternativ kann natürlich auch für die unterschiedlichen Teilsysteme 210, 220 jeweils ein eigener Spannungssensor 114, 124 zur Bereitstellung der Spannungssensorsignale S₁₁₄, S₁₂₄ eingesetzt werden.

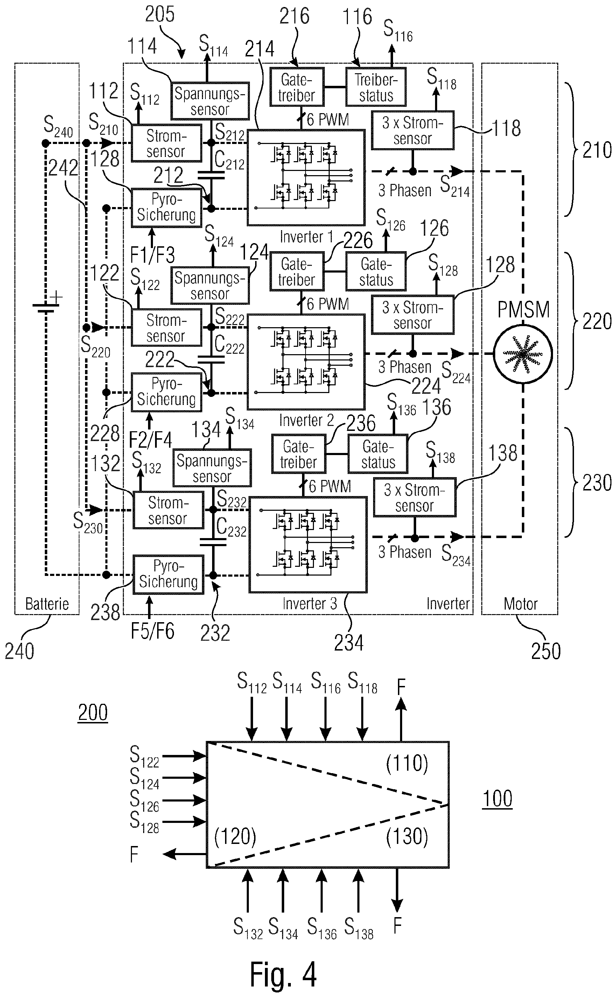

Ferner ist es bei einer Vielzahl von (zumindest drei) Teilsystemen 210, 220, 230 (siehe z.B. auch die Anordnung von Fig. 4) möglich, dass ein Teil (z.B. zwei) der Teilsysteme einen gemeinsamen Spannungssensor zum Bereitstellen des Spannungssensorsignals aufweist, wobei das verbleibende oder die verbleibenden Teilsysteme dann jeweils einen eigenen Spannungssensor zum Bereitstellen des jeweiligen Spannungssensorsignals aufweisen können.

Gemäß einem Ausführungsbeispiel können die Sensorelemente 112, 114 und 122, 124 ausgebildet sein, um das erste Stromsensorsignal S₁₁₂ und das erste Spannungssensorsignal S₁₁₄ und ferner das zweite Stromsensorsignal S₁₂₂ und das zweite Spannungssensorsignal S₁₂₄ zeitsynchron zueinander bereitzustellen. Damit kann eine zeitsynchrone Auswertung der Stromsensor- und Spannungssensorsignale durch die Fehlererkennungsanordnung 100 bzw. durch die erste und zweite (oder weitere) Fehlererkennungsvorrichtung 110, 120 erreicht werden.

Gemäß einem weiteren Ausführungsbeispiel kann die Fehlererkennungsanordnung ausgebildet, um das erste Stromsensorsignal S₁₁₂ und das erste Spannungssensorsignal S₁₁₄ und ferner das zweite Stromsensorsignal S₁₂₂ und das zweite Spannungssensorsignal S₁₂₄ für eine zeitsynchrone Auswertung zeitlich abzugleichen oder deren Signalverläufe aufzubereiten.

Durch die zeitliche Synchronisierung der Stromsensor- und Spannungssensorsignale können beispielsweise unterschiedliche Signallaufzeiten der Stromsensor- und Spannungssensorsignale bis zur Fehlererkennungsanordnung 100 oder unterschiedliche Erfassungs- und/oder Bereitstellungsgeschwindigkeiten der Sensorsignale durch die Sensorelemente berücksichtigt und ausgeglichen werden.

Eine "Signalaufbereitung" der Stromsensor- und Spannungssensorsignale zur Zeitsynchronisierung kann z.B. ein Entprellen oder die Verwendung eines Totzeitglieds (zur Signalverzögerung) umfassen. Fernern kann auch eine Kombination aus zeitlicher Synchronisation und Totzeitglied umgesetzt werden. Damit kann eine zeitsynchrone Auswertung der Stromsensor- und Spannungssensorsignale durch die Fehlererkennungsanordnung 100 bzw. durch die erste und zweite (oder weitere) Fehlererkennungsvorrichtung 110, 120 erreicht werden.

Eine zeitsynchrone Auswertung von Strom und Spannung, d.h. der Stromsensor- und Spannungssensorsignale, ermöglicht die Erkennung und Differenzierung zwischen Fehlerströmen und Ausgleichsströmen in dem elektrischen Gleichspannungsnetz 205.

Gemäß einem weiteren Ausführungsbeispiel kann die Fehlererkennungsanordnung 100 ferner ausgebildet sein, um das erste Fehlererkennungssignal F1 auszugeben, falls das erste Stromsensorsignal S₁₁₂ den ersten oberen Fehlerstromgrenzwert zumindest für eine vorgegebene Stromfehler-Zeitdauer T₁ (Zeitintervall) überschreitet, und um das zweite Fehlererkennungssignal F2 auszugeben, falls das zweite Stromsensorsignal S₁₂₂ den zweiten oberen Fehlerstromgrenzwert zumindest für eine vorgegebene Stromfehler-Zeitdauer T₂ überschreitet.

Fehler bzw. Fehlerzustände in einem der Teilsysteme 210, 220 mit geringer Auftrittsgeschwindigkeit benötigen zusätzliche Erkennungskriterien. Hierzu gehört die zeitliche Überschreitung, d.h. eine Überschreitung einer vorgegebenen Zeitdauer, eines einzelnen Grenzwertes und die zeitliche Unterschreitung von Minimalwerten (unteren Grenzwerten).

Gemäß einem weiteren Ausführungsbeispiel kann die Mehrzahl von Sensorsignalen S₁₁₂-S₁₁₈ und S₁₂₂-S₁₂₈ für die Fehlererkennungsanordnung 100 analoge Sensorsignale aufweisen. Die Verwendung von analogen Signalen (Sensorsignalen) im Zeitbereich macht eine Zeit-Diskretisierung überflüssig und steigert die Echtzeitfähigkeit der Fehlererkennung durch die Fehlererkennungsanordnung 100.

Gemäß einem weiteren Ausführungsbeispiel kann die Fehlererkennungsanordnung 100 als eine analoge Fehlererkennungsschaltung zur analogen Auswertung von analogen Sensorsignalen im Zeitbereich ausgebildet sein. Die Fehlererkennungseinheit 100 ist aufgrund der strukturellen Implementierung vollständig in Hardware realisierbar. Damit kann beispielsweise eine vereinfachte Zulassung und Zertifizierung der Fehlererkennungsanordnung 100 für Anwendungen in der Luftfahrt erreicht werden.

Gemäß Ausführungsbeispielen der erfindungsgemäßen Fehlererkennungsanordnung 100 kann auch alternativ oder zusätzlich eine digitale Implementierung oder Software-Implementierung der Fehlererkennungsanordnung 100 bzw. der ersten und/oder zweiten Signalauswerteschaltung 110, 120, z.B. für einen digitale Verarbeitung und/oder Aufbereitung von analogen oder digitalen Signalen S₁₁₂-S₁₁₈, S₁₂₂-S₁₂₈, eingesetzt werden.

Gemäß einem weiteren Ausführungsbeispiel können die Sensorsignale S₁₁₂-S₁₁₈, S₁₂₂-S₁₂₈ ferner erste Phasenstromsensorsignale S₁₁₈ basierend auf Phasensignalen S₂₁₄ des ersten Wechselrichters 214 in dem ersten Teilsystem 210 und zweite Phasenstromsensorsignale S₁₂₈ basierend auf den Phasensignalen S₂₂₄ des zweiten Wechselrichters 224 in dem zweiten Teilsystem 220 aufweisen. Die Fehlererkennungsanordnung 100 kann dann ferner ausgebildet sein, um das erste Fehlererkennungssignal F1 auszugeben, falls die Summe (der Amplituden) der Phasenströme S₂₁₄ gleich Null ist, und falls ferner (zumindest) eine der folgenden Bedingungen erfüllt ist: zumindest eines der ersten Phasenstromsensorsignale S₁₁₈ überschreitet einen ersten oberen Phasenfehlerstromgrenzwert, oder zumindest eines der ersten Phasenstromsensorsignale S₁₁₈ unterschreitet einen ersten unteren Phasenfehlerstromgrenzwert. Die Fehlererkennungsanordnung 100 kann dann ferner ausgebildet sein, um das zweite Fehlererkennungssignal F2 auszugeben, falls die Summe (der Amplituden) der Phasenströme S₂₂₄ gleich Null ist, und falls ferner (zumindest) eine der folgenden Bedingungen erfüllt ist: zumindest eines der zweiten Phasenstromsensorsignale S₁₂₈ überschreitet einen zweiten oberen Phasenfehlerstromgrenzwert, oder zumindest eines der zweiten Phasenstromsensorsignale S₁₂₈ unterschreitet einen zweiten unteren Phasenfehlerstromgrenzwert.

Fehler zwischen zwei oder dreiphasigen (oder allgemein mehrphasigen) Teilsystemen können durch die Auswertung der Summe (der Amplituden) der Phasenströme erkannt werden. Eine Summe ungleich null bedeutet, dass ein Fehler besteht bzw. vorliegt. Um ein falsche Erkennung von Fehlerzuständen zu vermeiden, werden bei der Festlegung und Einstellung der Grenzwerte beispielsweise Sensorfehler und Rauschen berücksichtig.

Gemäß einem weiteren Ausführungsbeispiel können die Sensorsignale ferner ein erstes Fehlerstromsensorsignal S₁₁₆ der ersten Treiberschaltungsanordnung 116 für den ersten Wechselrichter 214 in dem ersten Teilsystem 210 und ein zweites Fehlerstromsensorsignal S₁₂₆ der zweiten Treiberschaltungsanordnung 126 für den zweiten Wechselrichter 224 in dem zweiten Teilsystem 220 aufweisen. Die Fehlererkennungsanordnung 100 kann dann ferner ausgebildet sein, um das erste Fehlererkennungssignal F1 auszugeben, falls das erste Fehlerstromsensorsignal S₁₁₆ einen Fehlerstromzustand der ersten Treiberschaltungsanordnung 116 anzeigt, und um das zweite Fehlererkennungssignal F2 auszugeben, falls das zweite Fehlerstromsensorsignal S₁₂₆ einen Fehlerstromzustand der zweiten Treiberschaltungsanordnung 126 anzeigt.

Gemäß einem weiteren Ausführungsbeispiel ist der erste Wechselrichter 214 beispielsweise ausgebildet, um eine Mehrzahl von (n = 2, 3, ...) ersten Phasensignalen S₂₁₄ bereitzustellen, und der zweite Wechselrichter 224 ist beispielsweise ausgebildet, um eine Mehrzahl von (n = 2, 3, ...) zweiten Phasensignalen S₂₂₄ bereitzustellen. Der erste Wechselrichter 214 weist beispielsweise eine entsprechende Mehrzahl von (n = 2, 3, ...) ersten Phasenstromsensoren 118 zum Bereitstellen der Mehrzahl von (n = 2, 3, ...) ersten Phasenstromsensorsignalen S₁₁₈ basierend auf dessen Phasensignalen S₂₁₄ auf, wobei der zweite Wechselrichter 224 beispielsweise eine Mehrzahl von (n = 2, 3, ...) zweiten Phasenstromsensoren 128 zum Bereitstellen der Mehrzahl von (n = 2, 3, ...) zweiten Phasenstromsensorsignalen S₁₂₈ basierend auf dessen Phasensignalen S₂₂₄ aufweist.

Gemäß einem weiteren Ausführungsbeispiel kann das erste Teilsystem 210 ferner die erste Treiberschaltungsanordnung (Gate-Driver) 216 zur Ansteuern des ersten mehrphasigen Wechselrichters 214 und das zweite Teilsystem 220 ferner die zweite Treiberschaltungsanordnung (Gate-Driver) 226 zur Ansteuern des zweiten mehrphasigen Wechselrichters 224 aufweisen, wobei der erste Treiberschaltungsanordnung 216 ein erster Fehlerstromsensor (Fehlerzustandssensor) 116 (zum Erfassen des Driver- oder Gate-Status) zum Bereitstellen eines ersten Fehlerstromsensorsignals (Fehlerzustandssensorsignals) S₁₁₆ zugeordnet ist, falls die erste Treiberschaltungsanordnung 216 einen Fehlerzustand aufweist, und wobei der zweiten Treiberschaltungsanordnung 226 ein zweiter Fehlerstromsensor (Fehlerzustandssensor) 126 zum Bereitstellen eines zweiten Fehlerstromsensorsignals (Fehlerzustandssensorsignals) S₁₂₆ aufweist, falls die zweite Treiberschaltungsanordnung 226 einen Fehlerzustand aufweist.

Gemäß einem weiteren Ausführungsbeispiel kann das elektrische Gleichspannungsnetzwerk 205 eine elektrische Verteilerschaltung mit dem ersten und zweiten Teilsystem 210, 220 aufweisen, wobei beispielsweise die erste Fehlererkennungsvorrichtung 110 in dem ersten Teilsystem 210 der elektrischen Verteilerschaltung und die zweite Fehlererkennungsvorrichtung 120 in dem zweiten Teilsystem 220 der elektrischen Verteilerschaltung innerhalb des elektrischen Gleichspannungsnetzwerks 205 angeordnet sein kann.

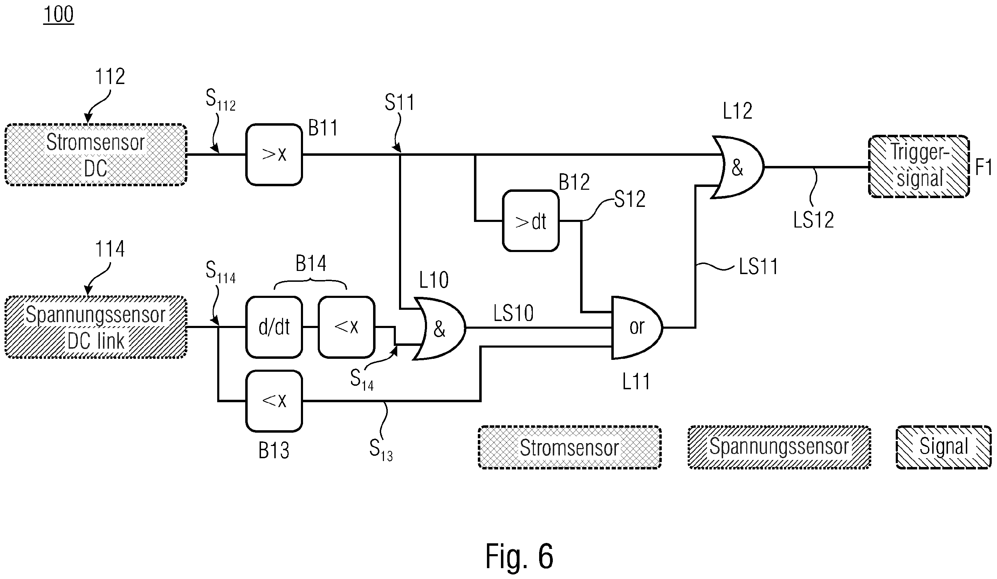

Ein solches Gleichspannungsnetzwerk 205 mit einer elektrischen Verteilerschaltung kann beispielsweise eine Vielzahl an Energiequellen 240 aufweisen. Hierzu können mehre Brennstoffzellen und Batterien gehören, welche jeweils einen Spannungswandler zwischen geschaltet haben, um eine konstante Zwischenkreisspannung S₂₁₂, S₂₁₂ in dem ersten und zweiten Zwischenkreis 212. 222 zu gewährleisten. Als Lasten 250 können beispielsweise mehrere Motoren 250 mit vorgeschalteten Wechselrichtern 214, 224 dienen, sowie auch andere Arten von Lasten und bidirektionale Spannungswandler. Eine Fehlererkennungsanordnung 100 für ein solches Gleichspannungsnetzwerk 205 ist beispielsweise als ein funktionales Blockdiagramm in Fig. 6 dargestellt.

Gemäß einem weiteren Ausführungsbeispiel kann die Fehlererkennungsanordnung 100 ferner ausgebildet sein, um ein drittes Fehlererkennungssignal F3 auszugeben, das einen weiteren elektrischen Fehlerzustand in dem ersten Teilsystem 210 angibt, falls das erste Stromsensorsignal S₁₁₂ einen ersten oberen Fehlerstromgrenzwert überschreitet und die Summe der ersten Phasenströme S₂₁₄ ungleich Null ist,
**oder**
falls das erste Stromsensorsignal S₁₁₂ einen ersten unteren Fehlerstromgrenzwert unterschreitet und die Summe der ersten Phasenströme S₂₁₄ ungleich Null ist, und falls ferner eine der folgenden Bedingungen erfüllt ist:
- das erste Spannungssensorsignal S₁₁₄ unterschreitet einen ersten Spannungsgrenzwert,
- der Gradient des ersten Spannungssensorsignals S₁₁₄ unterschreitet einen zweiten negativen Gradienten-Grenzwert [negativer Grenzwert der Spannungsänderungsgeschwindigkeit (zeitliche Ableitung dU/dt)],
- zumindest eines der ersten Phasenstromsensorsignale S₁₁₈ überschreitet einen ersten oberen Phasenfehlerstromgrenzwert,
- zumindest eines der ersten Phasenstromsensorsignale S₁₁₈ unterschreitet einen ersten unteren Phasenfehlerstromgrenzwert, oder
- das erste Überstromsensorsignal S₁₁₂ zeigt einen Überstromzustand der ersten Treiberschaltungsanordnung an.

Die Fehlererkennungsanordnung 100 kann nun ferner ausgebildet sein, um ein viertes Fehlererkennungssignal F4 auszugeben, das einen weiteren elektrischen Fehlerzustand in dem zweiten Teilsystem 220 angibt, falls das zweite Stromsensorsignal S₁₂₂ einen zweiten oberen Fehlerstromgrenzwert überschreitet und die Summe der zweiten Phasenströme S₂₂₄ ungleich Null ist,
**oder**
falls das zweite Stromsensorsignal S₁₂₂ einen zweiten unteren Fehlerstromgrenzwert unterschreitet und die Summe der zweiten Phasenströme S₂₂₄ ungleich Null ist, und falls ferner eine der folgenden Bedingungen erfüllt ist:
- das zweite Spannungssensorsignal S₁₂₄ unterschreitet einen zweiten Spannungsgrenzwert,
- der Gradient des zweiten Spannungssensorsignals S₁₂₄ unterschreitet einen zweiten negativen Gradienten-Grenzwert (negativer Grenzwert der Spannungsänderungsgeschwindigkeit (zeitliche Ableitung dU/dt)),
- zumindest eines der zweiten Phasenstromsensorsignale S₁₂₈ überschreitet einen zweiten oberen Phasenfehlerstromgrenzwert,
- zumindest eines der zweiten Phasenstromsensorsignale S₁₂₈ unterschreitet einen zweiten unteren Phasenfehlerstromgrenzwert, oder
- das zweite Überstromsensorsignal S₁₂₂ zeigt einen Überstromzustand der zweiten Treiberschaltungsanordnung an.

Wie in dem schematischen Schaltungsdiagramm von Fig. 1 ferner beispielhaft dargestellt ist, kann die Fehlererkennungsanordnung 100 als eine zentralen Signalauswerteschaltung in oder an dem elektrischen Gleichspannungsnetzwerk 205 angeordnet sein, wobei die erfassten Sensorsignale zentral verarbeitet werden können, um die Fehlersignale F₁ - F₄.

Gemäß einem weiteren Ausführungsbeispiel kann die erfindungsgemäße Fehlererkennungsanordnung 100 auch als eine modulare (örtlich getrennte) Anordnung ausgebildet sein. So kann die Fehlererkennungsanordnung ferner eine dritte und eine vierte Fehlererkennungsvorrichtung 130, 140 (eine dritte und vierte Signalauswerteschaltung) aufweisen, wobei die dritte Fehlererkennungsvorrichtung 130 dem ersten Teilsystem 210 zugeordnet ist und ausgebildet ist, um das dritte Fehlererkennungssignal F3 auszugeben, das den weiteren elektrischen Fehlerzustand in dem ersten Teilsystem 210 angibt, und wobei die vierte Fehlererkennungsvorrichtung 140 dem zweiten Teilsystem 220 zugeordnet ist und ausgebildet ist, um das vierte Fehlererkennungssignal F4 auszugeben, das den weiteren elektrischen Fehlerzustand in dem zweiten Teilsystem 220 angibt.

Gemäß einem weiteren Ausführungsbeispiel kann die Fehlererkennungsanordnung 100 beispielweise in einem mehrphasigen Wicklungssystem 200 eines Elektromotors 250 mit einem eigenen Wechselrichter 214, 224 in dem ersten und in dem zweiten Teilsystem 210, 220 angeordnet sein.

Gemäß einem weiteren Ausführungsbeispiel kann die Fehlererkennungsanordnung 100 ausgebildet sein, um eine Signaloperation an zumindest einem der Sensorsignale S₁₁₂-S₁₁₈ und S₁₂₂-S₁₂₈ durchzuführen, wobei die Signaloperation zumindest eine der folgenden Operationen aufweist: eine Differenzierung, eine Integration, eine Komparation, eine Filterung, eine Verstärkung, eine Modulation und Demodulation, und ein Überschreiten eines (oberen) Grenzwertes bzw. ein Unterschreiten eines (unteren) Grenzwertes für eine gewisse Zeitdauer.

Gemäß einem weiteren Ausführungsbeispiel kann das elektrische Gleichspannungsnetzwerk 205, z.B. in dem ersten Teilsystem 210, eine erste Trennanordnung oder ein erstes Trennelement 216 aufweisen, die/das ausgebildet ist, um bei Ausgabe des ersten oder dritten Fehlererkennungssignals F1, F3 das erste Teilsystem 210 elektrisch von dem elektrischen Gleichspannungsnetzwerk 205 zu trennen, und kann eine zweite Trennanordnung oder ein zweites Trennelement 228, z.B. in dem zweiten Teilsystem 220, aufweisen, die/das ausgebildet ist, um bei Ausgabe des zweiten oder vierten Fehlererkennungssignals F2, F4 das zweite Teilsystem 220 elektrisch von dem elektrischen Gleichspannungsnetzwerk 205 zu trennen.

Als die Trennanordnung (Trennelement) 218, 228 kann beispielsweise eine Pyro-Sicherung (Pyro-Fuse) oder ein Pyro-Schalter (Pyro-Switch) als aktives Sicherungselement eingesetzt werden. Eine Pyro-Sicherung ist beispielweise eine irreversible, mechanische Sicherung. Ein Pyro-Schalter ist beispielweise ein irreversibler, mechanischer Schalter. Die Pyro-Sicherung bzw. der Pyro-Schalter unterbricht den Strom in kritischen Situationen in dem Teilsystem, das den Fehlerzustand aufweist, wobei das jeweilige Fehlersignal F₁, F₂, F₃ oder F₄ ausgegeben wurde, das die Pyro-Sicherung bzw. den Pyro-Schalter auslöst. Solche Trennelemente 218, 228 werden also beispielsweise in den Teilsystemen 210, 220 eingesetzt, in denen die elektrische Sicherheit von entscheidender Bedeutung ist.

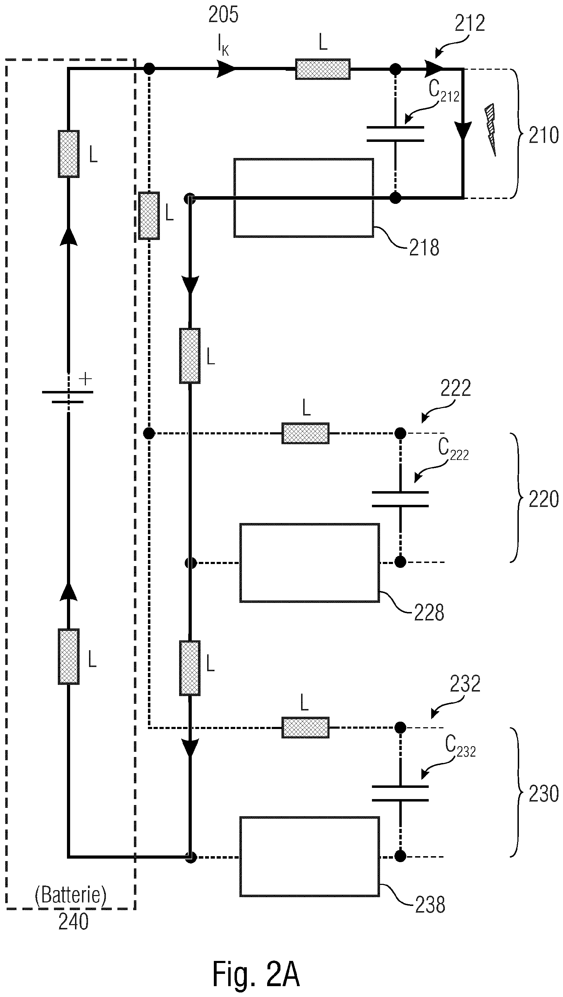

Fig. 2a-b zeigen nun jeweils ein schematisches Schaltungsdiagramm des zu überwachenden elektrischen Gleichspannungsnetzwerks 205 während eines zu erfassenden Fehlerzustands, z. B in Form eines elektrischen Kurzschlusses, in einem der drei Teilsysteme 210, 220, 230 gemäß einem Ausführungsbeispiel. Das in Fig. 2a-b dargestellte Ausführungsbeispiel ist aber gleichermaßen auf ein Gleichspannungsnetzwerk 205 mit zwei Teilsystemen 210, 220 oder auch mit weiteren (d.h. mehr als drei) Teilsystemen anwendbar.

In dem in Fig. 2a-b dargestellten Ausführungsbeispiel weist das zu überwachende elektrische Gleichspannungsnetzwerk 205 beispielsweise drei Teilsysteme 210, 220, 230 auf, wobei in dem schematischen Schaltungsdiagramm nur der jeweilige Zwischenkreis 212, 222, 232 mit den Zwischenkreiskondensatoren C₂₁₂, C₂₂₂, C₂₃₂ der Teilsysteme 210, 220, 230 mit den zugeordneten Trennanordnungen 218, 228, 238 und die Energiequelle 240 zur Vereinfachung der Beschreibung dargestellt sind. Ferner sind mehrere (parasitäre) Induktivitäten L eingezeichnet, die im Fall eines Kurzschlusses mit dem erhöhten Fehlerstrom in dem "defekten" (fehlerhaften) Teilsystem 210 sog. Ausgleichsströme in den fehlerfreien Teilsystemen 220, 230 bewirken (können).

Wie in Fig. 2a-b beispielhaft dargestellt ist, tritt in dem Teilsystem 210 ein Kurzschlussfehler in dem Zwischenkreis 212 und dem resultierenden Kurzschlussstrom I_{K} in dem Gleichspannungsnetzwerk 205 auf.

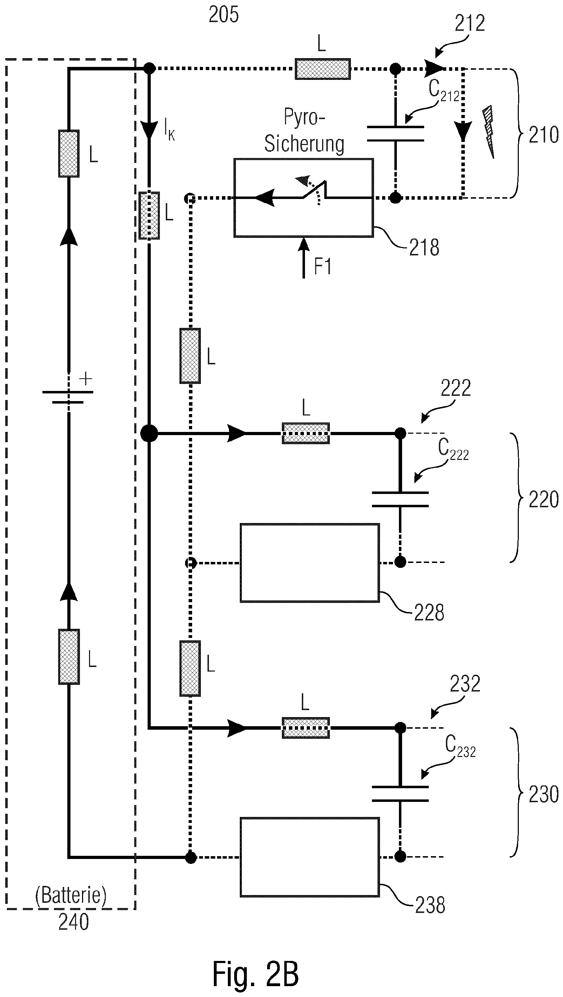

Die im vorhergehenden anhand von Fig. 1 beschriebene Strom-/Spannungsbeziehung bei der Erfassung eines Fehlerzustands in einem der Teilsysteme 210, 220, 230 des elektrisches Gleichspannungsnetzwerks 205 ermöglicht eine Unterscheidung zwischen Ausgleichsströmen und Fehlerströmen in den Teilsystemen 210, 220, 230. Liegt ein Fehler (Kurzschluss) in dem Teilsystem 210 vor, sinkt die Spannung (Zwischenkreisspannung) S₂₁₂ bei einem erhöhten Eingangsstrom (Fehlerstrom) S₂₁₀ in dem betroffenen Teilsystem 210. Basierend auf dieser Strom-/Spannungsbeziehung bei der Erfassung eines Fehlerzustands kann nun die Fehlererkennungsanordnung 100 mit dem Fehlersignal F1 das Trennelement 218 aktivieren und das erste fehlerhafte Teilsystem 210 elektrisch von dem elektrischen Gleichspannungsnetzwerk 205 trennen, wie in Fig. 2b dargestellt. Die Störung wird somit durch das Öffnen bzw. Aktivieren des Trennelements (der Sicherung) 218 geklärt.

Die Energiequelle 240 ist weiterhin aktiv (im Betriebszustand) und die Gleichspannungsverbindung (DC-Link) zu den weiteren Teilsystem 220, 230 vorhanden. Bei der Aktivierung des Trennelements (der Sicherung) 218 können aber hohe Ströme, z.B. Ausgleichsströme aufgrund der parasitären Induktivitäten L und/oder der Zwischenkreiskapazitäten 222, 232, sowohl in dem fehlerhaften Teilsystem 210 als auch in den weiteren fehlerfreien Teilsystemen 220, 230 auftreten.

Die Strom-/Spannungsbeziehung bei der Erfassung eines Fehlerzustands in einem der Teilsysteme 210, 220, 230 des elektrisches Gleichspannungsnetzwerks 205 ermöglicht eine Unterscheidung zwischen Ausgleichsströmen (= kein Fehlerzustand) und Fehlerströmen (= Fehlerzustand) in den Teilsystemen 210, 220, 230, da in einem fehlerfreien Teilsystem, d.h. den Teilsystemen 220 und 230 in Fig. 2a-b, die Spannung (Zwischenkreisspannung) S₂₂₂, S₂₃₂ bei einem negativen oder verringerten Eingangsstrom (Fehlerstrom) S₂₂₀, S₂₃₀ sinkt. In den fehlerfreien Teilsystemen 220, 230 wird daher mit der erfindungsgemäßen Fehlererkennungsanordnung 100 erfasst, dass kein Fehlerzustand vorliegt, sodass keines der Trennelemente 228, 238 in den Teilsystemen 220, 230 aktiviert bzw. ausgelöst, solange kein weiterer Fehlerzustand (wie oben beschrieben) in einem dieser Teilsysteme 220, 230 erkannt wird.

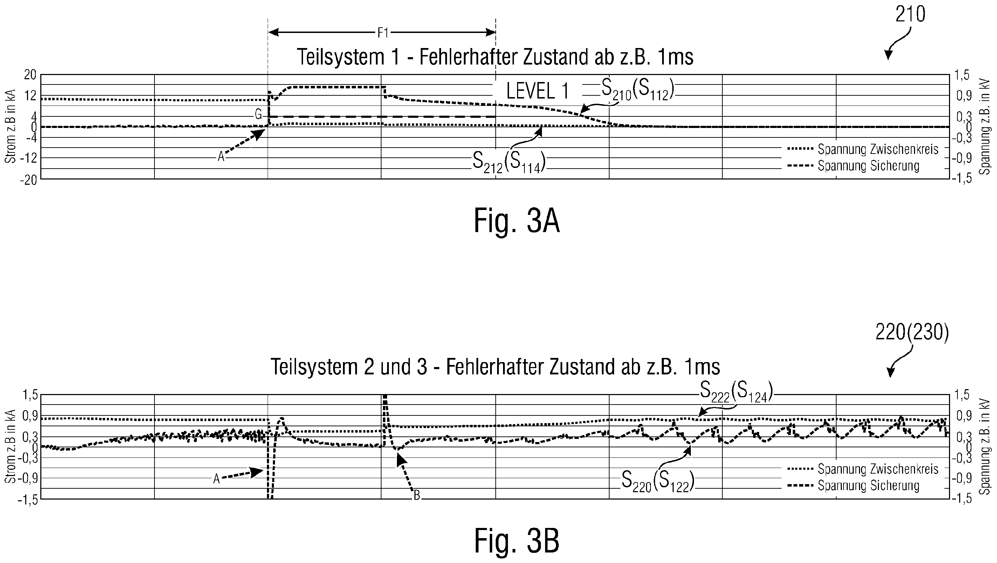

Die Fig. 3a-b zeigen nun graphische Darstellungen und Verläufe von Messgrößen in Form des erfassten Stromsensorsignals S₁₁₂ und des erfassten Spannungssensorsignals S₁₁₄ des fehlerhaften Teilsystems 210 und des erfassten Stromsensorsignals S₁₂₂ und des erfassten Spannungssensorsignal S₁₂₄ des fehlerfreien Teilsystems 220, 230 des zu überwachenden elektrischen Gleichspannungsnetzwerks 205.

Wie in Fig. 3a dargestellt ist, erfolgt zum Zeitpunkt A ein Fehler (Kurzschluss) in dem Teilsystem 210, wobei die Spannung (Zwischenkreisspannung) S₂₁₂ bei einem erhöhten Eingangsstrom (Fehlerstrom) S₂₁₀ in dem betroffenen Teilsystem 210 sinkt.

Wie nun in Fig. 3b dargestellt ist, sinkt zum Zeitpunkt A (mit dem Fehler in dem Teilsystem 210) in dem fehlerfreien Teilsystem 220 bzw. 230 die Spannung (Zwischenkreisspannung) S₁₁₄ bei einem negativen oder verringerten Eingangsstrom (Fehlerstrom) S₂₄₀. Ferner treten zum Zeitpunkt B die Ausgleichsströme in dem fehlerfreien Teilsystem 220 bzw. 230 auf, die aber aufgrund der Strom-/Spannungsbeziehung bei der Erfassung eines Fehlerzustands als Fehlerzustand ausgeschlossen werden können.

Zusammenfassend kann also festgestellt werden, dass die Fehlererkennungseinheit 100 Fehlerströme durch den Abgleich der Strom- und Spannungsbeziehung erkennt. Lastsprünge und die mit der Fehlerklärung auftretenden Nachladeströme und Ausgleichsströme können so korrekt zugeordnet werden. Die Induktivitäten L und die Zwischenkreiskapazitäten C₂₁₂, C₂₂₂, C₂₃₂ führen zu einem pulsierenden Verhalten (= Schwingungen) der Spannungen S₂₁₂, S₂₂₂, S₂₃₂ und des Stroms S₂₁₀, S₂₂₀, S₂₃₀, sowohl im fehlerhaften Teilsystem 210, als auch im fehlerfreien Teilsystem 220, 230. Diese Schwingungen werden beispielsweise durch die niederohmigen Kondensatoren der Zwischenkreiskapazitäten C₂₁₂, C₂₂₂, C₂₃₂ begünstigt, da die Kondensatoren der Zwischenkreiskapazitäten C₂₁₂, C₂₂₂, C₂₃₂ im Allgemeinen für hohe Leistungen mit einem geringen ESR (equivalent series resistance) und geringen Leistungswiderständen ausgelegt sind. Dies könnte zu einer fehlerhaften Auslösung des Trennelements 228 oder 238 führen, würde nur der Strom betrachtet werden. Durch die Hinzunahme der Spannungsänderung kann zwischen Ausgleichsströmen (= kein Fehlerzustand) und Fehlerströmen (= Fehlerzustand) unterschieden werden. Liegt ein Fehler vor, sinkt die Spannung bei einem erhöhten Strom. In einem fehlerfreien Teilsystem sinkt die Spannung bei einem negativen oder verringerten Strom.

Wie in Fig. 3a-b ferner beispielhaft dargestellt ist, kann zusätzlich ein Fehler (Fehlerzustand) durch das Überstromkriterium in Abhängigkeit eines Zeitgrenzwertes T1 erkannt werden. Ist der Strom für einen längeren Zeitabschnitt (Intervall) T1 erhöht, als dieser definierte Grenzwert G es zulässt, wird dieses Fehlerkriterium erfüllt. So sind auch Fehler erkennbar, welche auftreten, wenn bereits ein Fehler im System vorliegt oder langsam mit einem geringen Einfluss auf die Zwischenkreisspannung entstehen. Dies ist von besonderer Bedeutung für Fehler in Leistungszweigen mit deutlich geringerer Nennleistung verglichen mit der Gesamtsystemleistung. Gleiches gilt für die Erweiterung mit einem festen Unterspannungsgrenzwert.

In der nachfolgenden Tabelle 1 sind Beispiele für Fehler genannt, welche sicher und zuverlässig durch die erfindungsgemäße Fehlererkennungsanordnung 100 erkannt werden. Des Weiteren kann durch die erfindungsgemäße Fehlererkennungsanordnung 100 erkannt werden, ob ein Fehler bzw. Fehlerzustand innerhalb des Überwachungsbereichs der Fehlererkennungsanordnung oder außerhalb dieses Bereichs liegt.

### Tabelle 1 "Beispiele an zu erkennenden Fehlern in einem elektrischen Gleichspannungsnetzwerk"

**Tabelle 1 Beispiele an zu erkennenden Fehlern**

| Fehlerart | Fehlerfall |
|---|---|
| Symmetrischer Kurzschlussfehler | Zwischenkreiskondensator |
| Symmetrischer Kurzschlussfehler | Halbleiterbrücke |
| Symmetrischer Kurzschlussfehler | Zwischen drei Motorphasen |
| Symmetrischer Kurzschlussfehler | Zwischen zwei Leitern |
| Asymmetrische Kurzschlussfehler | Leistungsschalter Low-Side |
| Asymmetrische Kurzschlussfehler | Leistungsschalter High-Side |
| Asymmetrische Kurzschlussfehler | Zwischen zwei Motorphasen |
| Asymmetrische Kurzschlussfehler | Zwischen zwei Teilsystemen |

Im Folgenden werden technische Probleme bzw. Problemstellungen an die Fehlererkennung in einem elektrischen Gleichspannungsnetzwerk zusammengefasst, die mit der erfindungsgemäßen Fehlererkennungsanordnung gelöst werden können:
Die Erkennung und die Differenzierung zwischen Fehler und Ausgleichsströmen im elektrischen Gleichspannungsnetz ist durch die zeitsynchrone Auswertung von Strom und Spannung möglich.

Fehler zwischen Teilsystemen bzw. zueinander elektrisch isolierten Teilsystemen eines Motors können durch die Auswertung der Summe der Phasenströme erkannt werden. Eine Summe ungleich null bedeutet, dass ein Fehler vorliegt. Sensorfehler und Rauschen sollten jedoch bei der Festlegung von Grenzwerten berücksichtig werden.

Negative Fehlerströme sind eine Besonderheit von Fehlern zwischen zwei, bzw. dreiphasigen Teilsystemen. Fehler zwischen diesen zwei Teilsystemen können zuverlässiger und schneller durch die Erkennung von negativen Eingangsströmen erkannt werden.

Fehler mit geringer Auftrittsgeschwindigkeit benötigen zusätzliche Erkennungskriterien. Hierzu gehört die zeitliche Überschreitung eines einzelnen Grenzwertes und Unterschreitung von Minimalwerten.

Durch das Verwenden von mindestens zwei Fehlerkriterien zur Erkennung eines Fehlers wird ein Höchstmaß an Zuverlässigkeit und Robustheit erreicht.

Die Fehlererkennungseinheit ist aufgrund der strukturellen Implementierung vollständig in Hardware realisierbar. Vorteile wie eine vereinfachte Zulassung in der Luftfahrt können aus dieser Möglichkeit gewonnen werden. In der Luftfahrt ist die Zertifizierung von softwarebasierten Implementierungen von sicherheitskritischen Anwendungen komplex.

Die Verwendung von analogen Signalen im Zeitbereich macht eine Zeit-Diskretisierung überflüssig und steigert die Echtzeitfähigkeit.

Eine modulare Struktur ergibt sich aufgrund der Unabhängigkeit von externen Signalen. Dies umfasst sämtliche Signale, welche nicht von dem zu schützendem Teilsystem generiert werden.

Fig. 4 ein schematisches Schaltungsdiagramm eines zu überwachenden elektrischen Gleichspannungsnetzwerks 205 mit der Fehlererkennungsanordnung 100 gemäß einem weiteren Ausführungsbeispiel, wobei das elektrische Gleichspannungsnetzwerk 205 beispielsweise als ein elektrischer, Batterie 240 betriebener Antriebsstrang 200 eines neunphasigen Motors 250 mit drei voneinander isolierten Teilsystemen 210, 220, 230 ausgebildet ist.

Bevor nachfolgend das Ausführungsbeispiel von Fig. 4 näher erläutert wird, wird nochmals darauf hingewiesen, dass identische, funktionsgleiche oder gleichwirkende Elemente, Objekte, Funktionsblöcke und/oder Verfahrensschritte in den unterschiedlichen Figuren mit den gleichen Bezugszeichen versehen sind, so dass die in unterschiedlichen Ausführungsbeispielen dargestellte Beschreibung dieser Elemente, Objekte, Funktionsblöcke und/oder Verfahrensschritte (mit gleichen Bezugszeichen) untereinander austauschbar ist bzw. aufeinander angewendet werden kann.

Der allgemeine Aufbau des betrachteten Antriebsstrangs 200 ist in Fig. 4 beispielhaft dargestellt. Es ist zu erkennen, dass eine Batterie 240 die Gesamtenergie des Systems 200 liefert, die über ein Hauptgleichstromverbindungskabel 242 mit drei unabhängigen Teilsystemen 210, 220, 230 verbunden ist. Jedes dieser Teilsysteme 210, 220, 230 stellt drei Phasen S₂₁₄, S₂₂₄, S₂₃₄ der neun Motorphasen bereit. Bei der verwendeten Motortopologie handelt es sich beispielsweise um einen oberflächenmontierten Permanentmagnet-Synchronmotor (PMSM) 250, der z.B. drei isolierte Wicklungssysteme mit jeweils drei Phasen in Sternschaltung aufweist. Die Sternpunkte des Motors sind gegen Erde isoliert.

Dies ermöglicht eine unabhängige und zu anderen Teilsystemen isolierte Stromerzeugung. Jedes der Teilsysteme 210, 220, 230 umfasst einen Zwischenkreiskondensator C₂₁₂, C₂₂₂, C₂₃₂, einen B6-Brückenwechselrichter 214, 224, 234 mit unabhängigen Sensoren 112, 114, 116, 118, 122, 124, 126, 128, und 132, 134, 136 und 138, Gate-Treibern 116, 126, 136 und eine Pyro-Sicherung (Pyrofuse) 218, 228, 238. Aufgrund des kurzen Abstands und der niederohmigen Verbindungen zwischen den Zwischenkreiskondensatoren C₂₁₂, C₂₂₂, C₂₃₂ können sich Fehlerströme auf die Zwischenkreise 212, 222, 232 zwischen den Teilsystemen 210, 220, 230 ausbreiten.

Einer wichtiger Faktor bei diesem Ansatz können beispielsweise die verwendeten Sensoren darstellen. Diese Sensoren 112, 114, 116, 118, 122, 124, 126, 128, und 132, 134, 136 und 138 sind mit ihrem jeweiligen Standort in Fig. 4 dargestellt. Jedes Teilsystem 210, 220, 230 verfügt über eine Gleichspannungsmessung 114, 124, 134 am Zwischenkreiskondensator C₂₁₂, C₂₂₂, C₂₃₂ und eine Gleichstrommessung 112, 122, 132 vor dem Kondensator C₂₁₂, C₂₂₂, C₂₃₂. Der Gleichstromsensor112, 122, 132 befindet sich auf der Hochpotentialseite, während die Pyrosicherung 218, 228, 238 auf der Niederpotentialseite der Zwischenkreisverbindung jedes Teilsystems 210, 220, 230 angeordnet ist. Dementsprechend entspricht der gemessene Durchschnittsstrom dem gemittelten Strom durch die Pyrosicherung 218, 228, 238. Darüber hinaus wird jeder der Motorphasenströme S₂₁₄, S₂₂₄, S₂₃₄ überwacht. Die von den Gate-Treibern 216, 226, 236 gelieferten Statussignale enthalten ein Fehlersignal S₁₁₆, S₁₂₆, S₁₃₆ für jeden Leistungshalbleiter der Brückenwechselrichter 214, 224, 234. Dieses Fehlersignal S₁₁₆, S₁₂₆, S₁₃₆ wird zum Beispiel durch einen DESAT- oder Temperaturfehler verursacht. Innerhalb des Treibers 216, 226, 236 werden diese beispielsweise als High-Side- (FLTHS) und Low-Side- (FLTLS) Ausgangsfehler S₁₁₆, S_{116'} bezeichnet.

In einem möglichen Anwendungsbeispiel wird die Fehlerüberwachung 100 in einem neunphasigen Motor 250 für drei unterschiedliche Teilsysteme 210, 220, 230 modular umgesetzt. Jedes Teilsystem 210, 220, 230 kann eine eigene und unabhängige Fehlererkennungseinheit 110, 120, 130. Der Antriebsstrang mit der Sensorik ist in Fig. 4 beispielhaft dargestellt.

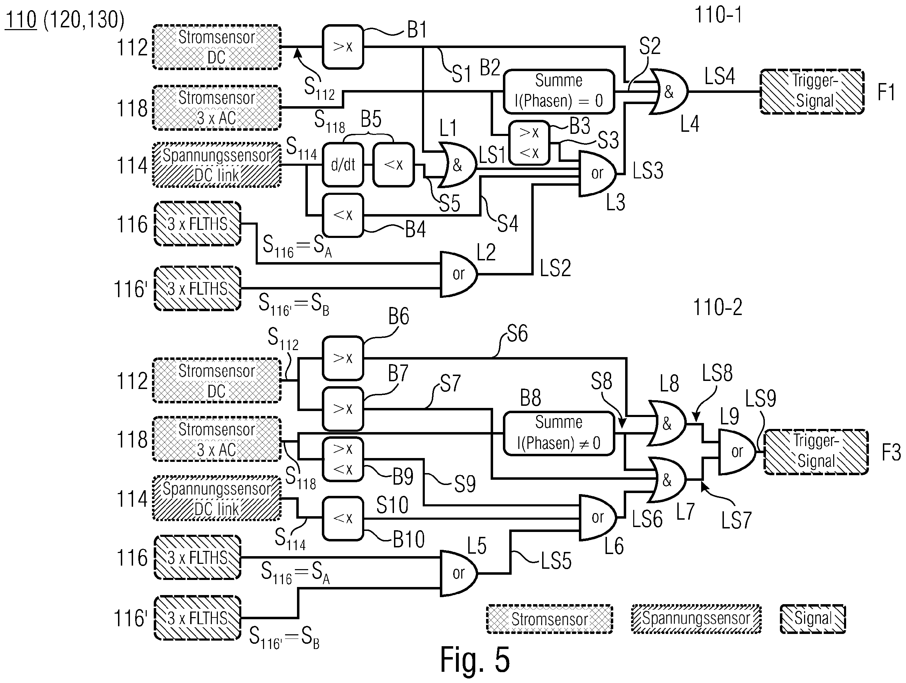

Fig. 5 zeigt nun eine schematische Darstellung eines funktionales Blockdiagramms der erfindungsgemäßen Fehlererkennungsanordnung 100 gemäß einem weiteren Ausführungsbeispiel. Jedes Teilsystem 210, 220, 230 kann eine eigene und unabhängige Fehlererkennungseinheit 110, 120, 130, die beispielsweise gleich aufgebaut sind, aufweisen, da auch die Teilsysteme 210, 220, 230 beispielsweise gleich aufgebaut sind. In der nachfolgenden Beschreibung anhand von Fig. 5 wird exemplarisch die Fehlererkennungseinheit 110 des Teilsystems 210 beschrieben, wobei die nachfolgenden Ausführungen gleichermaßen auf die weiteren Fehlererkennungseinheiten 120, 130, ... der weiteren Teilsysteme 220, 230, ... anwendbar sind.

Wie in Fig. 5 dargestellt ist, werden von den Sensoren 112, 114, 116, 116', 118 die Sensorsignale S₁₁₂, S₁₁₄, S₁₁₆, S_{116'}, S₁₁₈ bereitgestellt. Der Schaltungsteil 110-1 der Fehlererkennungseinheit 110 der Fehlererkennungsanordnung 100 weist nun, wie in Fig. 5 dargestellt, eine Reihe von Grenzwertbewertungseinheiten B1 - B10 (in Hardware und/oder Software) und eine Reihe von Logikblockeinheiten L1 - L9 (in Hardware und/oder Software) auf. Die Grenzwertbewertungseinheiten B1 - B10 führen eine Grenzwertbewertung des jeweiligen Sensorsignals durch und geben ein entsprechendes Bewertungssignal S1 - S10 aus. Das Bewertungssignal weist abhängig von dem Bewertungsergebnis einen entsprechenden Signalpegel (High = logisch "1" oder Low = logisch "0") aufweist. Für den Fall, dass das jeweilige Sensorsignal nicht im Sollbereich (fehlerfreien Bereich) liegt, wird beispielsweise das Sensorbewertungssignal S1 - S10 mit einem hohen Pegel (logisch "1") ausgegeben, während für den Fall, dass sich das jeweilige Sensorsignal in einem fehlerfreien Bereich (im Sollbereich) befindet, ein niedriger Pegel (logisch "0") für das Sensorbewertungssignal S1 - S10 ausgegeben wird.

Den Logikeinheiten L1 - L9 werden nun jeweils mehrere der Bewertungssignalen S1 - S10 zugeführt, um jeweils eine Logik-Operation mit den zugeführten Bewertungssignalen (bzw. deren logischen Zuständen) durchführen. Als Ergebnis geben die Logikelemente L1 - L9 dann entsprechend der Logikoperation der Bewertungssignale ein Logiksignal LS1 - LS9 aus.

Hinsichtlich der in Fig. 5 dargestellten Anordnung sollte deutlich werden, dass auch komplementäre Bewertungssignale S1 - S10 ausgegeben werden können, wobei dann die Logikelemente L1 - L9 eine komplementäre Logikoperation durchführen.

Das Bewertungselement (Block) B1 bewertet nun, ob das erste Stromsensorsignal S₁₁₂ einen ersten oberen Fehlerstromgrenzwert überschreitet und gibt das entsprechende Bewertungssignal S1 aus. Das Bewertungselement (Block) B2 erfasst nun, ob die Summe der Phasenströme der Phasenstromsensorsignale S₁₁₈ (gleich) = 0 ist und gibt ein entsprechendes Bewertungssignal S2 aus.

Die Bewertungseinheit B3 bewertet nun die Phasenstromsensorsignale S₁₁₈, ob zumindest eines der Phasenstromsensorsignale einen ersten oberen Phasenfehlerstromgrenzwert überschreitet oder zumindest eines der Phasenstromsensorsignale einen Phasenfehlerstromgrenzwert unterschreitet, und gibt ein entsprechendes Bewertungssignal S3 aus.

Die Bewertungseinheit B4 bewertet nun, ob das Spannungssensorsignal S₁₄ einen Spannungsgrenzwert unterschreitet und gibt ein entsprechendes Bewertungssignal S4 aus. Die Bewertungseinheit B5 bewertet nun, ob der Gradient des Spannungssensorsignals S₁₄ einen negativen Gradienten-Grenzwert unterschreitet, und gibt ein entsprechendes Bewertungssignal S5 aus. Die Sensorsignale S₁₁₆ und S_{116'} werden beispielsweise als Bewertungssignale S_{A}, S_{B} bereitgestellt.

Das Logikelement L1 führt nun eine logische Und-Operation der Signale S1 und S5 durch und gibt das Logiksignal LS1 aus. Das Logikelement L2 führt eine logische ODER-Operation der Bewertungssignale S_{A} und S_{B} durch und gibt das Logiksignal S2 aus. Das Logikelement L3 führt nun eine logische ODER-Operation mit den Bewertungssignalen S3, S4 und den Logiksignalen LS1, LS2 durch und gibt ein entsprechendes Logiksignal LS3 aus. Das Logikelement L4 führt nun eine logische UND-Operation der Bewertungssignale S1, S2 und dem Logiksignal S3 aus, und gibt das Logiksignal LS4 aus, das dem Fehlersignal F1 entspricht.

Der Schaltungsteil 110-2 der Fehlererkennungseinheit 110 von Fig. 5 führt nun folgende Signaloperationen mit den Sensorsignalen S₁₁₂, S₁₁₄, S₁₁₆, S_{116'} und S₁₁₈ durch.

Die Signalbewertungseinheit (Block) B6 bewertet nun, ob das Stromsensorsignal S₁₁₂ einen oberen Fehlerstromgrenzwert überschreitet und gibt ein entsprechendes Bewertungssignal S6 aus. Die Bewertungseinheit B7 bewertet, ob das Stromsensorsignal S₁₁₂ einen unteren Fehlerstromgrenzwert unterschreitet und gibt ein entsprechendes Bewertungssignal S7 aus. Die Bewertungseinheit B8 bewertet, ob die Summe der Phasenströme des Phasenstromsensorsignals S₁₁₈ (ungleich) ≠ 0 ist, und gibt ein entsprechendes Bewertungssignal S8 aus.

Die Bewertungseinheit B9 bewertet, ob zumindest eines der Phasenstromsensorsignale S₁₁₈ einen oberen Phasenfehlerstromgrenzwert überschreitet oder ob zumindest eines der Phasenstromsensorsignale einen unteren Phasenfehlerstromgrenzwert unterschreitet und gibt ein entsprechendes Bewertungssignal S9 aus. Das Sensorsignalbewertungselement B10 bewertet nun, ob das Spannungssensorsignal S₁₁₄ einen Spannungsgrenzwert unterschreitet und gibt ein entsprechendes Bewertungssignal S10 aus. Ferner werden die Sensorsignale S₁₁₆, S_{116'} als Bewertungssignale S_{A}, S_{B} bereitgestellt.

Das Logikelement L5 führt nun eine logische ODER-Operation der Bewertungssignale S_{A}, S_{B} durch und gibt ein entsprechendes Logiksignal LS5 aus. Das Logikelement L6 führt nun eine ODER-Operation der Bewertungssignale S9, S10 und des Logiksignals LS5 durch und gibt ein entsprechendes Logiksignal LS6 aus. Das Logikelement L7 führt nun eine logische UND-Operation der Bewertungssignale S7, S8 und des Logiksignals LS6 durch. Das Logikelement L8 führt nun eine logische UND-Operation der Bewertungssignale S6, S8 durch und gibt ein entsprechendes Logiksignal LS8 aus. Das Logikelement L9 führt eine logische oder-Operation der Logiksignale LS7, LS8 durch und gibt ein entsprechendes Logiksignal LS9 aus, das dem Fehlersignal F3 entspricht.

Eine mögliche grundsätzliche Umsetzung dieser Fehlererkennungseinheit 110 ist nun in Fig. 5 als Fehlererkennungseinheit 110 für einen dreiphasigen Motor 250 dargestellt. Als Eingangssignale werden der Eingangsgleichstrom S₂₁₀, welcher den Wechselrichter 214 versorgt, die Phasenströme S₂₁₆ des Motors 250, die Zwischenkreisspannung S₂₁₂ am Eingang des Wechselrichters 214 und die Fehlersignale S₂₁₆, S_{216'} (FLTHS, FLTLS) der Leistungshalbleiter bzw. deren Sensorsignale S₁₁₂, S₁₁₈, S₁₁₄, S₁₁₆, S_{116'} verwendet. In diesem Fall wird das Ausgangssignal (Fehler- oder Triggersignal) F1, F3 zur Ansteuerung einer aktiven Sicherung 218 verwendet.

Die Schaltung 110 ist in zwei parallelen (ähnlichen) Logikschaltungen 110-1, 110-2 dargestellt, welche jeweils die Fehlererkennung durchführen. Für eine bessere Verständlichkeit ist eine Auftrennung in zwei Logikschaltungen dargestellt. Die (obere) Schaltung 110-1 erkennt alle Fehler, außer den Kurzschlussfehlern zwischen zwei Teilsystemen in einem Motor. Diese Teilsysteme sind dreiphasige Wicklungssysteme, welche über einen eigenen Wechselrichter verfügen und innerhalb des Motors zu anderen Teilsystemen voneinander elektrisch isoliert sind. Die (untere) Schaltung 110-2 ist speziell für die Erkennung von Fehlern zwischen zwei, bzw. dreiphasigen voneinander isolierten Wicklungssystemen konfiguriert.

Die Unterscheidung zwischen den beiden Schaltungsteilen 110-1, 110-2 erfolgt durch die Überprüfung (in Block B2), ob die Summe der Phasenströme in einem dreiphasigen Teilsystem gleich Null ist. In einem finalen UND-Glied L4 wird die obere Schaltung 110-1 blockiert, wenn die Summe der Phasenströme ungleich Null ist. Gleichzeitig wird beispielweise die untere Schaltung 110-2 aktiviert. Diese Trennung kann aus zwei Gründen notwendig sein. Der erste Grund ist, dass die im oberen Logikteil 110-1 erkannten Fehler nur positive Fehlerströme generieren, weshalb eine fehlerhafte Erkennung durch das Entladen der jeweiligen Zwischenkreiskapazitäten C₂₁₂ verhindert wird. Der zweite Grund ist, dass negative Kurzschlussströme bei Fehlern zwischen zwei Teilsystemen möglich sind und daher sollten sie nicht für diesen Fehler ausgeschlossen werden.

Dies ist beispielsweise (besonders) wichtig, da der Sicherungsstrom S₂₁₆ die gesamte erste Periode nach dem Fehler negativ sein kann. Eine Erkennung innerhalb dieser Periode wäre somit ohne negative Überstromerkennung nicht möglich, obwohl die Amplituden der Spitzenwerte größer als der Grenzwert für diese sind.

In beiden Teilen 110-1, 110-2 der Logikschaltung 110 hat der Sicherungsstrom S₂₁₀ unter den ausgewerteten Fehlerkriterien die höchste Priorität. Der Sicherungsstrom 210 (mit dem zugehörigen Stromsensorsignal S₁₁₂) ist auch das einzige Fehlerkriterium, das beispielsweise bei jedem erkannten Fehler anliegt. Dadurch ist sichergestellt, dass kein Fehlersignal F1, F3 erfolgt, ohne dass ein Fehlerstrom fließt. Im oberen Teil 110-1 der Schaltung werden negative Eingangsströme von der Erkennung ausgeschlossen. Der Eingangsstrom S₂₁₀ ist der Strom, welcher den Wechselrichter 214 für das Teilsystem 210 auf der Gleichspannungsseite versorgt.

Durch Erreichen des Grenzwertes (>X in Block B1) für einen positiv erhöhten Sicherungsstroms und die Bedingung, dass die Summe der Phasenströme gleich Null (Block B2) ist, sind beispielsweise sämtliche niederohmigen Fehler (Fehlerzustände in dem Teilsystem) zuverlässig abgedeckt. Eine Ausnahme bilden jedoch die Kurzschlussfehler, welche über die Leistungsschalter des Wechselrichters 214 geschaltet werden. Ein weiterer zu beachtender Punkt sind die Ausgleichströme mit einer erfolgreichen Trennung oder Klärung eines niederohmigen Fehlers oder sprunghafte Laständerungen. Diese könnten im fehlerfreien Teilsystem eine falsche Auslösung verursachen. Die dabei auftretenden Nachladeströme der Zwischenkreiskapazitäten führen beispielsweise zu einem pulsierenden Verhalten der Spannungen und des Stroms, sowohl in einem fehlerhaften, als auch in einem fehlerfreien Teilsystem. Die damit verbundene mögliche falschen Fehlererkennung kann, durch die Hinzunahme des Spannungskriteriums verhindert werden. Die Strom-/Spannungsbeziehung ermöglicht eine Unterscheidung zwischen Ausgleichsströmen und Fehlerströmen. Liegt ein Fehler vor sinkt, die Spannung S₂₁₂ bei einem erhöhten Eingangsstrom S₂₁₀. In einem fehlerfreien Teilsystem sinkt die Spannung S₂₁₂ bei einem negativen oder verringerten Eingangsstrom S₂₁₀.

Sollte die Erkennung des Spannungseinbruchs so verschoben sein, dass diese gleichzeitig mit einem positiven Stromfluss auftritt, kann es zu einer fehlerhaften Einordnung kommen und damit zu einer falsch positiven Fehlererkennung. Daher kann beispielsweise ein in der Realität auftretenden Zeitversatz kompensiert werden, beispielsweise vor dem Abgleich zwischen dem Erkennen einer absinkenden Zwischenkreisspannung und einem Überstromkriterium.

Beim Versuch der DESAT-Fehlererkennung S₁₁₆, S_{116'} fehlerhafte Leistungshalbleiter des Wechselrichters 214 zu öffnen, könnte es zu einer Abschaltenergie kommen, die zur Zerstörung der Leistungshalbleiter führen kann. Deshalb kann ein DSAT-Fehler S₁₁₆, S_{116'} auftreten, ohne dass eine Reaktion des defekten Leistungsschalters erkennbar ist. Es ist auch möglich, dass der Fehlerstrom reduziert wird oder der Fehler vollständig geklärt. Nur der letzte Fall braucht beispielsweise nicht von der Fehlererkennungseinheit als Fehler erkannt werden.

Insgesamt werden redundante Fehlerkriterien für die Erkennung von Fehlern verwendet. In diesem Fall werden sämtliche anderen Fehlerkriterien, als zusätzliche Redundanz integriert. Hierzu gehört die DESAT-Fehlererkennung der Leistungshalbleiter, die Erkennung von Überströmen in den Phasen S₂₁₆ und das Unterschreiten einer bestimmten Spannungsgrenze im Zwischenkreis 212. Es sind daher immer mindestens zwei anliegende Fehlerkriterien nötig, um einen Fehler zu erkennen. Für Fehler, welche zu einem sehr langsamen Anstieg des Stroms und damit zu einer geringen Absenkungsgeschwindigkeit der Zwischenkreisspannung S₂₁₂ führen, liegt ein minimaler Grenzwert für das Unterspannungskriterium vor. Fehler, welche vor allem die Motorphasenströme S₂₁₆ betreffen, aber in verminderten Ausmaßen die Gleichspannungsseite des Wechselrichters 214, können durch Hinzunahme der Phasenströme besser erkannt werden. Gleiches gilt für Kurzschlussfehler im Wechselrichter 214 oder Motor 250, die auch zu erhöhten Fehlerströme in den Motorphasen führt. Die Fehlersignale S₁₁₆, S_{116'} der Leistungshalbleiter können Fehler besser erkennbar machen, welche von der DESAT-Erkennung in ihrem Ausmaß deutlich verringert werden.

Bis auf drei Änderungen entspricht der untere Aufbau 110-2 grundsätzlich dem oberen Aufbau 110-1. Das Unterscheidungskriterium sind die Summenströme (Summe der Phasenströme in Block B8), die ungleich Null sind. Die zusätzliche Erkennung von negativen Sicherungsströmen als Fehlerkriterium stellt einen Unterschied dar. Die Spannungsänderungen sind in diesem Fehler weniger ausgeprägt, was die zuverlässige Erkennung erschwert. Zusätzlich ist zu erwarten, dass der positive und negative Fehlerstrom zwischen den zwei, bzw. dreiphasigen Teilsystemen die Zwischenkreisspannung S₂₁₂ unabhängig vom Sicherungsstrom S₂₁₆ beeinflusst. Der minimale Spannungswert (Block B10) als redundante Erweiterung, um niederohmige Fehler erkennen zu können, bleibt jedoch bestehen.

In dieser Variante der Erkennungsschaltung 110 wird beispielsweise kein Unterschied gemacht, ob der Kurzschlussfehler zwischen zwei Teilsystemen am Klemmpunkt oder am Sternpunkt auftritt. Eine solche Unterscheidung ist zwar möglich und würde eine selektives Erkennungsverhalten ermöglichen, wird jedoch in dieser potenziellen Umsetzung nicht weiter differenziert, da eine Erkennung in beiden Teilsystemen gewollt ist. Eine Möglichkeit, dies zu erfassen, besteht darin zu überprüfen, ob der Phasenstrom S₂₁₄ in einer oder in mindestens zwei Phasen eines dreiphasigen Teilsystems 210 erhöht ist. Damit kann unterschieden werden, ob der Fehler am Sternpunkt (mindestens zwei Phasenströme erhöht) oder an den Klemmen (nur ein Phasenstrom erhöht) vorliegt.

Eine aktive DESAT-Fehlerbehandlung in dem anderem betroffenen Teilsystem kann das Auftreten eines zusätzlichen Fehlerkriteriums verhindern. Daher erfolgt die Trennung bereits bei der Erkennung von positiven Sicherungsströmen. Das Fehlerkriterium des positiven Sicherungsstroms (Block B6) und der Summenströme ungleich Null (Block B8) bilden dennoch die Identifizierung von zwei unabhängigen Signalen und bieten damit zusätzliche Sicherheit vor Rauschen oder anderen Störsignalen.

Der negative Fehlerstrom (Block B7) führt nur unter der Erkennung weiterer Fehlerkriterien zur Auslösung des Fehlersignals F3, da negative Sicherungsströme in der Regel nur in fehlerfreien Teilsystemen auftreten. Eine Ausnahme bildet der Fehler zwischen zwei dreiphasigen Teilsystemen. Damit ist die Auswerteschaltung deutlich zuverlässiger.

Im Folgenden werden nochmals die Bedingungen zusammengefasst, bei denen die Fehlererkennungsanordnung 100 von Fig. 5 das erste Fehlererkennungssignal F1 (Trigger-Signal oder Auslösesignal) ausgibt.
- falls das erste Stromsensorsignal S₁₁₂ einen ersten oberen Fehlerstromgrenzwert überschreitet und falls ferner (zumindest) eine der folgenden Bedingungen erfüllt ist: Das erste Spannungssensorsignal S₁₁₄ unterschreitet einen ersten Spannungssensorgrenzwert oder der Gradient des ersten Spannungssensorsignals S₁₁₄ unterschreitet einen ersten negativen Gradienten-Grenzwert, d.h. einen negativen Grenzwert der Spannungsänderungsgeschwindigkeit (zeitlich Ableitung dU/dt).
- falls das erste Stromsensorsignal S₁₁₂ den ersten oberen Fehlerstromgrenzwert zumindest für eine vorgegebene Stromfehler-Zeitdauer T₁ (Zeitintervall) überschreitet, und um das zweite Fehlererkennungssignal F2 auszugeben, falls das zweite Stromsensorsignal S₁₂₂ den zweiten oberen Fehlerstromgrenzwert zumindest für eine vorgegebene Stromfehler-Zeitdauer T₂ überschreitet.
- falls die Summe (der Amplituden) der Phasenströme S₂₁₄ gleich Null ist, und falls ferner (zumindest) eine der folgenden Bedingungen erfüllt ist: zumindest eines der ersten Phasenstromsensorsignale S₁₁₈ überschreitet einen ersten oberen Phasenfehlerstromgrenzwert, oder zumindest eines der ersten Phasenstromsensorsignale S₁₁₈ unterschreitet einen ersten unteren Phasenfehlerstromgrenzwert. Die Fehlererkennungsanordnung 100 kann dann ferner ausgebildet sein, um das zweite Fehlererkennungssignal F2 auszugeben, falls die Summe (der Amplituden) der Phasenströme S₂₂₄ gleich Null ist, und falls ferner (zumindest) eine der folgenden Bedingungen erfüllt ist: zumindest eines der zweiten Phasenstromsensorsignale S₁₂₈ überschreitet einen zweiten oberen Phasenfehlerstromgrenzwert, oder zumindest eines der zweiten Phasenstromsensorsignale S₁₂₈ unterschreitet einen zweiten unteren Phasenfehlerstromgrenzwert.
- das erste Fehlerstromsensorsignal S₁₁₆ einen Fehlerstromzustand der ersten Treiberschaltungsanordnung 116 anzeigt, und um das zweite Fehlererkennungssignal F2 auszugeben, falls das zweite Fehlerstromsensorsignal S₁₂₆ einen Fehlerstromzustand der zweiten Treiberschaltungsanordnung 126 anzeigt.

Im Folgenden werden nochmals die Bedingungen zusammengefasst, bei denen die Fehlererkennungsanordnung 100 das erste Fehlererkennungssignal F3 (Trigger-Signal oder Auslösesignal) ausgibt.
- falls das erste Stromsensorsignal S₁₁₂ einen ersten oberen Fehlerstromgrenzwert überschreitet und die Summe der ersten Phasenströme S₂₁₄ ungleich Null ist,
   **oder**
- falls das erste Stromsensorsignal S₁₁₂ einen ersten unteren Fehlerstromgrenzwert unterschreitet und die Summe der ersten Phasenströme S₂₁₄ ungleich Null ist, und falls ferner eine der folgenden Bedingungen erfüllt ist:
   - das erste Spannungssensorsignal S₁₁₄ unterschreitet einen ersten Spannungsgrenzwert,
   - der Gradient des ersten Spannungssensorsignals S₁₁₄ unterschreitet einen zweiten negativen Gradienten-Grenzwert [negativer Grenzwert der Spannungsänderungsgeschwindigkeit (zeitliche Ableitung dU/dt)],
   - zumindest eines der ersten Phasenstromsensorsignale S₁₁₈ überschreitet einen ersten oberen Phasenfehlerstromgrenzwert,
   - zumindest eines der ersten Phasenstromsensorsignale S₁₁₈ unterschreitet einen ersten unteren Phasenfehlerstromgrenzwert, oder
   - das erste Überstromsensorsignal S₁₁₂ zeigt einen Überstromzustand der ersten Treiberschaltungsanordnung an.

Fig. 6 zeigt nun eine schematische Darstellung eines funktionales Blockdiagramms einer erfindungsgemäßen Fehlererkennungsanordnung 100 gemäß einem weiteren Ausführungsbeispiel. Jedes Teilsystem 210, 220, 230 kann eine eigene und unabhängige Fehlererkennungseinheit 110, 120, 130 aufweisen. Diese können beispielsweise gleich aufgebaut sind, falls auch die Teilsysteme 210, 220, 230 gleich aufgebaut sind. In der nachfolgenden Beschreibung anhand von Fig. 6 wird exemplarisch die Fehlererkennungseinheit 110 des Teilsystems 210 beschrieben, wobei die nachfolgenden Ausführungen gleichermaßen auf weitere Fehlererkennungseinheiten 120, 130, ... von weiteren Teilsystemen 220, 230, ... anwendbar sind.

Wie in Fig. 6 beispielhaft dargestellt ist, werden das Stromsensorsignal S₁₁₂ des Stromsensors 112 und das Spannungssensorsignal S₁₁₄ des Spannungssensors 114 hinsichtlich eines Fehlerzustands ausgewertet.

Der Schaltungsteil 110-2 der Fehlererkennungseinheit 110 weist nun, wie in Fig. 6 dargestellt, eine Reihe von Grenzwertbewertungseinheiten B11 - B14 (in Hardware und/oder Software) und eine Reihe von Logikblockeinheiten L10 - L12 (in Hardware und/oder Software) auf. Die obigen allgemeinen Ausführungen in Fig. 5 zu den dortigen Grenzwertbewertungseinheiten und den Logikblockeinheiten sind auch hier in Fig. 6 anwendbar.

Wie in Fig. 6 dargestellt ist, wird in einem Signalbewertungselement (Block) B11 bewertet, ob das Stromsensorsignal S₁₁₂ einen oberen Fehlerstromgrenzwert überschreitet und ein entsprechendes Bewertungssignal S11 ausgegeben. In dem Bewertungselement B12 wird bewertet, ob das Bewertungssignal B11 zumindest eine vorgegebene Stromfehler-Zeitdauer vorliegt, d. h., das Stromsensorsignal S₁₁₂ den oberen Fehlerstromgrenzwert zumindest für eine vorgegebene Stromfehler-Zeitdauer überschreitet, wobei ein entsprechendes Bewertungssignal S12 ausgegeben wird. Die Bewertungseinheit B13 bewertet, ob das Spannungssensorsignal S₁₁₄ einen unteren Spannungsgrenzwert unterschreitet und gibt ein entsprechendes Bewertungssignal S13 aus. Die Bewertungseinheit B14 bewertet, ob der Gradient des Spannungssensorsignals S₁₁₄ einen negativen Gradienten-Grenzwert unterschreitet und gibt ein entsprechendes Bewertungssignal S14 aus.

Ein Logikelement L10 führt nun eine logische UND-Operation der Bewertungssignale S11, S14 durch und gibt ein entsprechendes Logiksignal LS10 aus. Das Logikelement L11 führt nun eine logische ODER-Operation der Bewertungssignale S12, S13 und des Logiksignals LS10 durch, und gibt ein entsprechendes Logiksignal LS11 aus. Das Logikelement L12 führt nun eine logische UND-Operation des Bewertungssignals S11 und des Logiksignals LS11 aus und gibt ein entsprechendes Logiksignal LS12 aus, das dem Fehlersignal F1 von Fig. 6 entspricht.

Ein weiteres Ausführungsbeispiel ist die Fehlererkennungseinheit 100 in einer Verteilerbox (Verteilerschaltung) innerhalb eines Gleichspannungsnetzes 205. Dieses Gleichspannungsnetz 205 weist beispielsweise eine Mehrzahl von Energiequellen 240 auf. Hierzu gehören beispielsweise mehrere Brennstoffzellen und Batterien, welche jeweils einen Spannungswandler zwischen geschaltet haben, um eine konstante Zwischenkreisspannung S₂₁₂ zu gewährleisten. Als Lasten 250 dienen mehrere Motoren mit vorgeschalteten Wechselrichtern 214, sowie andere Arten an Lasten und bidirektionale Spannungswandler. Eine Fehlererkennungseinheit 100 ist beispielhaft in Fig. 6 dargestellt.

Die Fehlererkennungseinheit 100 erkennt Fehlerströme S₂₁₀ durch den Abgleich der Strom- und Spannungsbeziehung. Lastsprünge und die mit der Fehlerklärung auftretenden Nachladeströme und Ausgleichsströme können so korrekt zugeordnet werden. Die Zwischenkreiskapazitäten führen zu einem pulsierenden Verhalten der Spannungen und des Stroms, sowohl im fehlerhaften, als auch im fehlerfreien Teilsystem. Dies könnte zu einer fehlerhaften Auslösung führen, würde nur der Strom S₂₁₀ betrachtet werden. Durch die Hinzunahme der Spannungsänderung kann zwischen Ausgleichsströmen und Fehlerströmen unterschieden werden. Liegt ein Fehler in dem Teilsystem 210 vor, sinkt die Spannung S₂₁₂ bei einem erhöhten Strom S₂₁₀. In einem fehlerfreien Teilsystem 210 sinkt die Spannung S₂₁₂ bei einem negativen oder verringerten Strom S₂₁₀.

Zusätzlich kann die Erkennungseinheit 100 einen Fehler in dem Teilsystem 210 durch das Überstromkriterium (Block B11) in Abhängigkeit eines Zeitgrenzwertes (Block B12) erhalten. Ist der Strom S₂₁₀ (bzw. das zugeordnete Stromsensorsigna S₁₁₂) für einen längeren Zeitabschnitt T1 erhöht, als dieser definierte Wert es zulässt, wird dieses Fehlerkriterium erfüllt. So sind auch Fehler erkennbar, welche auftreten, wenn bereits ein Fehler im System vorliegt oder langsam mit einem geringen Einfluss auf die Zwischenkreisspannung S₂₁₂ entstehen. Dies ist von besonderer Bedeutung für Fehler in Leistungszweigen mit deutlich geringerer Nennleistung verglichen mit der Gesamtsystemleistung. Gleiches gilt für die Erweiterung mit einem festen Unterspannungsgrenzwert.

Signaloperationen, welche mit den analogen Eingangssignalen S₁₁₂, S₁₁₄ durchgeführt werden, umfassen z.B. eine Differenzierung, eine Integration, eine Komparation, eine Filterung, eine Verstärkung, eine Modulation und Demodulation und eine Überschreiten eines Grenzwertes für eine gewisse Zeit.

Im Folgenden werden nochmals die Bedingungen zusammengefasst, bei denen die Fehlererkennungsanordnung 100 von Fig. 5 das erste Fehlererkennungssignal F1 (Trigger-Signal oder Auslösesignal) ausgibt.

Falls das erste Stromsensorsignal einen ersten oberen Fehlerstromgrenzwert überschreitet und falls ferner (zumindest) eine der folgenden Bedingungen erfüllt ist:
- das erste Spannungssensorsignal unterschreitet einen ersten Spannungsgrenzwert, oder
- der Gradient des ersten Spannungssensorsignals unterschreitet einen ersten negativen Gradienten-Grenzwert [negativer Grenzwert der Spannungsänderungsgeschwindigkeit (zeitliche Ableitung dU/dt)], oder
- das erste Stromsensorsignal überschreitet den ersten oberen Fehlerstromgrenzwert zumindest für eine vorgegebene Stromfehler-Zeitdauer.

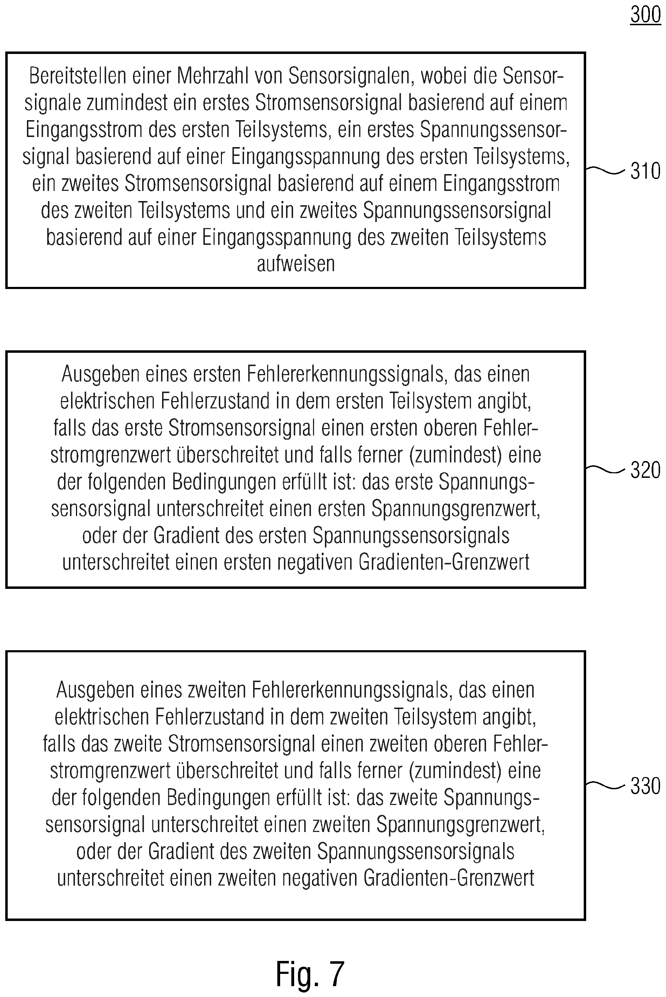

Fig. 7 zeigt nun eine schematische Darstellung eines Flussdiagramms des erfindungsgemäßen Verfahrens 300 zur Fehlererkennung in einem zu überwachenden elektrischen Gleichspannungsnetzwerk 205 gemäß einem weiteren Ausführungsbeispiel. Das Verfahrens 300 zur Fehlererkennung in einem zu überwachenden elektrischen Gleichspannungsnetzwerk 205 kann beispielsweise mit einer der im vorhergehenden beschriebenen Fehlererkennungsanordnung 100 durchgeführt werden.

Das Verfahren 300 zur Fehlererkennung in einem elektrischem Gleichspannungsnetzwerk, das (zumindest) ein erstes und ein zweites Teilsystem 210, 220 aufweist, weist folgende Schritte auf:
Bereitstellen 310 einer Mehrzahl von Sensorsignalen S₁₁₂-S₁₁₈ und S₁₂₂-S₁₂₈ (von einer Mehrzahl von Sensorelementen 112, 114, 116, 118 und 122, 124, 126, 128), wobei die Sensorsignale zumindest ein erstes Stromsensorsignal S₁₁₂ basierend auf einem Eingangsstrom S₂₁₆ des ersten Teilsystems, ein erstes Spannungssensorsignal S₁₁₄ basierend auf einer Eingangsspannung S₂₁₂ des ersten Teilsystems 210, ein zweites Stromsensorsignal S₁₂₂ basierend auf einem Eingangsstrom S₂₂₀ des zweiten Teilsystems 220 und ein zweites Spannungssensorsignal S₁₂₄ basierend auf einer Eingangsspannung S₂₂₂ des zweiten Teilsystems 220 aufweisen,
Ausgeben 320 eines ersten Fehlererkennungssignals F1, das einen elektrischen Fehlerzustand in dem ersten Teilsystem 210 angibt, falls das erste Stromsensorsignal S₁₁₂ einen ersten oberen Fehlerstromgrenzwert überschreitet und falls ferner (zumindest) eine der folgenden Bedingungen erfüllt ist:
   - das erste Spannungssensorsignal S₁₁₄ unterschreitet einen ersten Spannungsgrenzwert, oder
   - der Gradient des ersten Spannungssensorsignals S₁₁₄ unterschreitet einen ersten negativen Gradienten-Grenzwert [negativer Grenzwert der Spannungsänderungsgeschwindigkeit (zeitliche Ableitung dU/dt)], und
Ausgeben 330 eines zweiten Fehlererkennungssignals F3, das einen elektrischen Fehlerzustand in dem zweiten Teilsystem 220 angibt, falls das zweite Stromsensorsignal S₁₂₂ einen zweiten oberen Fehlerstromgrenzwert überschreitet und falls ferner (zumindest) eine der folgenden Bedingungen erfüllt ist:
   - das zweite Spannungssensorsignal S₁₂₄ unterschreitet einen zweiten Spannungsgrenzwert, oder
   - der Gradient des zweiten Spannungssensorsignals S₁₂₄ unterschreitet einen zweiten negativen Gradienten-Grenzwert [negativer Grenzwert der Spannungsänderungsgeschwindigkeit (zeitliche Ableitung dU/dt)].

Bei dem Verfahren 300 zur Fehlererkennung in einem elektrischem Gleichspannungsnetzwerk kann nun ferner ein zeitliches Abgleichen oder Aufbereiten 340 des ersten Stromsensorsignals S₁₁₂ und des ersten Spannungssensorsignal S₁₁₄ und ferner des zweiten Stromsensorsignals S₁₂₂ und des zweiten Spannungssensorsignal S₁₂₄ für eine zeitsynchrone Auswertung der Signalverläufe durchgeführt werden.

Das Verfahren 300 zur Fehlererkennung in einem elektrischem Gleichspannungsnetzwerk kann ferner folgende Schritte aufweisen:
Ausgeben 342 des ersten Fehlererkennungssignals, falls das erste Stromsensorsignal den ersten oberen Fehlerstromgrenzwert zumindest für eine vorgegebene Stromfehler-Zeitdauer überschreitet, und
Ausgeben 344 des zweiten Fehlererkennungssignals, falls das zweite Stromsensorsignal den zweiten oberen Fehlerstromgrenzwert zumindest für eine vorgegebene Stromfehler-Zeitdauer überschreitet.
Gemäß einem Ausführungsbeispiel können die Sensorsignale ferner erste Phasenstromsensorsignale basierend auf Phasensignalen eines ersten Wechselrichters in dem ersten Teilsystem und zweite Phasenstromsensorsignale basierend auf Phasensignalen eines zweiten Wechselrichters in dem zweiten Teilsystem aufweisen. Das Verfahren 300 zur Fehlererkennung in einem elektrischem Gleichspannungsnetzwerk kann dann ferner folgende Schritte aufweisen:
   Ausgeben 346 des ersten Fehlererkennungssignals, falls die Summe der Phasenströme gleich Null ist, und falls ferner (zumindest) eine der folgenden Bedingungen erfüllt ist:
      - zumindest eines der ersten Phasenstromsensorsignale überschreitet einen ersten oberen Phasenfehlerstromgrenzwert, oder
      - zumindest eines der ersten Phasenstromsensorsignale unterschreitet einen ersten unteren Phasenfehlerstromgrenzwert und
Ausgeben 348 des zweiten Fehlererkennungssignals, falls die Summe der Phasenströme gleich Null ist, und falls ferner (zumindest) eine der folgenden Bedingungen erfüllt ist:
   - zumindest eines der zweiten Phasenstromsensorsignale überschreitet einen zweiten oberen Phasenfehlerstromgrenzwert, oder
   - zumindest eines der zweiten Phasenstromsensorsignale unterschreitet einen zweiten unteren Phasenfehlerstromgrenzwert.
Gemäß einem Ausführungsbeispiel können die Sensorsignale ferner ein erstes Fehlerstromsensorsignal einer ersten Treiberschaltungsanordnung für den ersten Wechselrichter in dem ersten Teilsystem und ein zweites Fehlerstromsensorsignal einer zweiten Treiberschaltungsanordnung für den zweiten Wechselrichter in dem zweiten Teilsystem aufweisen. Das Verfahren 300 zur Fehlererkennung in einem elektrischem Gleichspannungsnetzwerk kann dann ferner folgende Schritte aufweisen:
   Ausgeben 350 des ersten Fehlererkennungssignals, falls das erste Fehlerstromsensorsignal einen Fehlerstromzustand der ersten Treiberschaltungsanordnung anzeigt,
      und
   Ausgeben 352 des zweiten Fehlererkennungssignals, falls das zweite Fehlerstromsensorsignal einen Fehlerstromzustand der zweiten Treiberschaltungsanordnung anzeigt. Gemäß einem Ausführungsbeispiel kann der erste Wechselrichter ausgebildet sein, um eine Mehrzahl von ersten Phasensignalen bereitzustellen, und wobei der zweite Wechselrichter ausgebildet ist, um eine Mehrzahl von zweiten Phasensignalen bereitzustellen. Das Verfahren 300 zur Fehlererkennung in einem elektrischem Gleichspannungsnetzwerk kann dann ferner folgende Schritte aufweisen:
      - Bereitstellen 354 einer Mehrzahl von ersten Phasenstromsensorsignalen (einer Mehrzahl von ersten Phasenstromsensoren) basierend auf den Phasensignalen des ersten Wechselrichters, und
      - Bereitstellen 356 einer Mehrzahl von zweiten Phasenstromsensoren (mit einer Mehrzahl von zweiten Phasenstromsensorsignalen) basierend auf den Phasensignalen des zweiten Wechselrichters
Gemäß einem Ausführungsbeispiel kann das erste Teilsystem ferner eine erste Treiberschaltungsanordnung zur Ansteuern des ersten mehrphasigen Wechselrichters und das zweite Teilsystem ferner eine zweite Treiberschaltungsanordnung zur Ansteuern des zweiten mehrphasigen Wechselrichters aufweisen, wobei die erste Treiberschaltungsanordnung einen ersten Fehlerstromsensor und die zweite Treiberschaltungsanordnung einen zweiten Fehlerstromsensor aufweist. Das Verfahren 300 zur Fehlererkennung in einem elektrischem Gleichspannungsnetzwerk kann dann ferner folgende Schritte aufweisen:
   Bereitstellen 358 eines ersten Fehlerstromsensorsignals, falls die erste Treiberschaltungsanordnung einen Fehlerzustand aufweist, und
   Bereitstellen 360 eines zweiten Fehlerstromsensorsignals, falls die zweite Treiberschaltungsanordnung einen Fehlerzustand aufweist.
Gemäß einem Ausführungsbeispiel kann die Fehlererkennungsanordnung eine erste und eine zweite Fehlererkennungsvorrichtung [erste und zweite Signalauswerteschaltung] aufweisen, wobei die erste Fehlererkennungsvorrichtung dem ersten Teilsystem und die zweite Fehlererkennungsvorrichtung dem zweiten Teilsystem zugeordnet ist. Das Verfahren 300 zur Fehlererkennung in einem elektrischem Gleichspannungsnetzwerk kann dann ferner folgende Schritte aufweisen:
   Bereitstellen 362 der Mehrzahl von Sensorsignalen (mit einer Mehrzahl von Sensorelementen) für die erste und die zweite Fehlererkennungsvorrichtung,
   Ausgeben 364 des ersten Fehlererkennungssignals mit der ersten Fehlererkennungsvorrichtung, das den elektrischen Fehlerzustand in dem ersten Teilsystem angibt, und
   Ausgeben 366 des zweiten Fehlererkennungssignals mit der zweiten Fehlererkennungsvorrichtung, das den elektrischen Fehlerzustand in dem zweiten Teilsystem angibt.

Das Verfahren 300 zur Fehlererkennung in einem elektrischem Gleichspannungsnetzwerk kann ferner folgende Schritte aufweisen:
Ausgeben 368 eines dritten Fehlererkennungssignals, das einen weiteren elektrischen Fehlerzustand in dem ersten Teilsystem angibt,
   falls das erste Stromsensorsignal einen ersten oberen Fehlerstromgrenzwert überschreitet und die Summe der ersten Phasenströme ungleich Null ist,
      **oder**
   falls das erste Stromsensorsignal einen ersten unteren Fehlerstromgrenzwert unterschreitet und die Summe der ersten Phasenströme ungleich Null ist, und falls ferner eine der folgenden Bedingungen erfüllt ist:
      - das erste Spannungssensorsignal unterschreitet einen ersten Spannungsgrenzwert,
      - der Gradient des ersten Spannungssensorsignals unterschreitet einen zweiten negativen Gradienten-Grenzwert [negativer Grenzwert der Spannungsänderungsgeschwindigkeit (zeitliche Ableitung dU/dt)],
      - zumindest eines der ersten Phasenstromsensorsignale überschreitet einen ersten oberen Phasenfehlerstromgrenzwert,
      - zumindest eines der ersten Phasenstromsensorsignale unterschreitet einen ersten unteren Phasenfehlerstromgrenzwert, oder
      - das erste Überstromsensorsignal zeigt einen Überstromzustand der ersten Treiberschaltungsanordnung an,
         und
Ausgeben 370 eines vierten Fehlererkennungssignals, das einen weiteren elektrischen Fehlerzustand in dem zweiten Teilsystem angibt,
   falls das zweite Stromsensorsignal einen zweiten oberen Fehlerstromgrenzwert überschreitet und die Summe der zweiten Phasenströme ungleich Null ist,
      **oder**
   falls das zweite Stromsensorsignal einen zweiten unteren Fehlerstromgrenzwert unterschreitet und die Summe der zweiten Phasenströme ungleich Null ist, und falls ferner eine der folgenden Bedingungen erfüllt ist:
      - das zweite Spannungssensorsignal unterschreitet einen zweiten Spannungsgrenzwert,
      - der Gradient des zweiten Spannungssensorsignals unterschreitet einen zweiten negativen Gradienten-Grenzwert [negativer Grenzwert der Spannungsänderungsgeschwindigkeit (zeitliche Ableitung dU/dt)],
      - zumindest eines der zweiten Phasenstromsensorsignale überschreitet einen zweiten oberen Phasenfehlerstromgrenzwert,
      - zumindest eines der zweiten Phasenstromsensorsignale unterschreitet einen zweiten unteren Phasenfehlerstromgrenzwert, oder
      - das zweite Überstromsensorsignal zeigt einen Überstromzustand der zweiten Treiberschaltungsanordnung an.

Gemäß einem Ausführungsbeispiel kann die Fehlererkennungsanordnung eine dritte und eine vierte Fehlererkennungsvorrichtung [dritte und vierte Signalauswerteschaltung] aufweisen, wobei die dritte Fehlererkennungsvorrichtung dem ersten Teilsystem zugeordnet ist und wobei die vierte Fehlererkennungsvorrichtung dem zweiten Teilsystem zugeordnet ist. Das Verfahren 300 zur Fehlererkennung in einem elektrischem Gleichspannungsnetzwerk kann dann ferner folgende Schritte aufweisen:
Ausgeben 372 des dritten Fehlererkennungssignals mit der dritten Fehlererkennungsvorrichtung, das den weiteren elektrischen Fehlerzustand in dem ersten Teilsystem angibt, und
Ausgeben 374 des vierten Fehlererkennungssignals mit der vierten Fehlererkennungsvorrichtung, das den weiteren elektrischen Fehlerzustand in dem zweiten Teilsystem angibt.

Gemäß einem Ausführungsbeispiel kann das elektrische Gleichspannungsnetzwerk eine erste und zweite Trennanordnung aufweisen. Das Verfahren 300 zur Fehlererkennung in einem elektrischem Gleichspannungsnetzwerk kann dann ferner folgende Schritte aufweisen:
Trennen 376 des ersten Teilsystems von dem elektrischen Gleichspannungsnetzwerk bei Ausgabe des ersten oder dritten Fehlererkennungssignals, und
Trennen 378 des zweiten Teilsystems von dem elektrischen Gleichspannungsnetzwerk bei Ausgabe des zweiten oder vierten Fehlererkennungssignals.

Nachfolgend werden nochmals einige beispielhafte Aspekte der erfindungsgemäßen Fehlererkennungsanordnung 100 für ein elektrisches Gleichspannungsnetzwerk 205 und des erfindungsgemäßen Verfahrens 300 zur Fehlererkennung in einem elektrischem Gleichspannungsnetzwerk 205 zusammengefasst.

Die Fehlererkennungseinheit 100 in einem DC-Netzwerk 205 umfasst mehrere Sensor- und Systemzustandseingänge, einschließlich Spannungs- und Stromsensorwerte, eine Erkennungsschaltung 100 (Auswerteschaltung) und ein Fehlererkennungsausgangssignal F1(F2 - F4). Die Erkennungsschaltung 100 kann Signaloperationen mit den Eingangssignalen durchführen und eine Fehlererkennungsentscheidung auf Grundlage der Eingangssignale und der durchgeführten Signaloperationen treffen. Die Fehlererkennungseinheit 100 ist beispielsweise in der Lage, Fehler mit relevanten Kurzschlussströmen oder Fehlerverhalten in dem Gleichspannungsnetzwerk 205 zu erkennen.

Die Fehlererkennungseinheit nutzt für die Erkennung eines relevanten Fehlers ein Strom-/Spannungsbeziehung zwischen Eingangsstrom (Fehlerstrom) und Spannung (Zwischenkreisspannung), wie z.B. ein Grenzwertüberschreitung des Gleichstroms (Eingangsstrom oder Fehlerstrom) und der Eingangsspannung (Zwischenkreisspannung).

Ein Überstromkriterium liegt dann vor, wenn ein Grenzwert überschritten wird oder eine Stromanstiegsgeschwindigkeit überschritten wird. Ein Unterstromkriterium liegt dann, wenn ein Grenzwert unterschritten wird oder eine Stromabsink-Geschwindigkeit unterschritten wird.

Eine zeitsynchrone Auswertung von Strom und Spannung ermöglicht die Erkennung und Differenzierung zwischen Fehler und Ausgleichsströmen im elektrischen Gleichspannungsnetzen.

Die Fehlererkennungseinheit 100 kann vollständig softwarefrei (z.B. ausschließlich) Hardware-Komponenten aufweisen. Die Auswertung erfolgt auf analoge Weise und nutzt beispielsweise logische Gatterelemente.

Die Hardwareimplementierung der Fehlererkennungseinheit 100 kann auch als Software-Variante in verschiedenen Arten von Steuereinheiten, Controllern, FPGAs, ASICS oder in Computern implementiert werden.

Die Fehlererkennungseinheit 100 kann zur Steuerung oder Auslösung verschiedener Arten von Schaltern oder Sicherungen verwendet werden. Beispiele hierfür sind Relais, Solid-State Circuit Breaker (SSCB) und aktive Sicherungselemente, wie Pyrofuses oder Pyroswitches.

Zu zusätzlichen Eingangssignalen können Statussignale von Leistungsmodulen wie die Desat-Fehlererkennung gehören. Weitere Eingangssignale sind die Phasenströme des Motors sowie die Spannung des elektrischen Netztes 205 am Ort der Strommessung.

Signaloperationen für die Fehlererkennungseinheit 100, die mit den Eingangssignalen durchgeführt werden können, umfassen beispielsweise eine Differenzierung, eine Integration, eine Komparation, eine Filterung, eine Verstärkung, eine Modulation und Demodulation und eine Überschreiten eines Grenzwertes für eine gewisse Zeit.

Eine Grenzwertverletzung wird beispielsweise erkannt, wenn ein Signal einen festgelegten Schwellenwert überschreitet. Der Vergleichsparameter für den Grenzweit kann eine Eingangsgröße nach der Nutzung einer oder mehrere der Signaloperationen sein.

Ein Fehlersignal kann beispielsweise auch erkannt werden, wenn ein Signal für eine bestimmte Zeit einen definierten Schwellenwert überschreitet. Die Fehlererkennungseinheit 100 kann beispielsweise innerhalb der Hauptverbindung eines Antriebsstrangs eingesetzt werden. Die Fehlererkennungseinheit 100 kann beispielsweise in der Motorantriebseinheit eines 3-Phasensystems oder eines Mehrphasensystems oder anderer Lastelemente eingesetzt werden. Die Fehlererkennungseinheit 100 kann beispielsweise für den Batterieschutz und für Anwendungen in der Luftfahrt geeignet und in der Automobilindustrie einsetzbar, und generell für den Einsatz in DC-Netzten geeignet.

Die erfindungsgemäße Fehlererkennungseinheit 100 kann beispielsweise zeitlich schnell auftretende Kurzschlussströme erfassen und ist damit in der Lage, einen Schutz für Batterien, Brennstoffzellen, kapazitive Energiespeicher oder für vergleichbare Energiespeicher oder für ein Gleichspannungsnetzwerk gespeist von solchen Energiespeichern zu gewährleisten.

Im Folgenden werden noch einige technisches Anwendungsgebiete für die erfindungsgemäße Fehlererkennungseinheit 100 angegeben. So kann die Fehlererkennungseinheit beispielsweise auf der Gleichstromseite von Wechselrichter, Gleichrichtern oder Wandlern, bei Batterien, Brennstoffzellen oder andere Formen von Energiequellen, innerhalb der Hauptverbindung eines Antriebsstrangs, in der Motorantriebseinheit eines 3-Phasensystems oder eines Mehrphasensystems oder anderer Lastelemente eingesetzt werden.

Im Rahmen der vorliegenden Beschreibung wurden Aspekte der Fehlererkennungsanordnung 100 im Zusammenhang mit einem Gerät beschrieben; es ist klar, dass diese Aspekte auch eine Beschreibung des entsprechenden Verfahrens darstellen. Der Betrieb der Fehlererkennungsanordnung 100 kann von einem Hardware-Gerät (oder unter Verwendung eines solchen) ausgeführt werden, z. B. einem Mikroprozessor, einem programmierbaren Computer oder einer elektronischen Schaltung. In einigen Ausführungsformen können einer oder mehrere der wichtigsten Verfahrensschritte durch ein solches Gerät ausgeführt werden.

Abhängig von bestimmten Implementierungsanforderungen können Ausführungsformen der Fehlererkennungsanordnung 100 in Hardware oder in Software oder zumindest teilweise in Hardware oder zumindest teilweise in Software implementiert werden. In einigen Ausführungsformen kann eine programmierbare Logikvorrichtung (z. B. ein feldprogrammierbares Gate-Array) verwendet werden, um einige oder alle der hierin beschriebenen Funktionalitäten der Fehlererkennungsanordnung 100 auszuführen. In einigen Ausführungsformen kann ein feldprogrammierbares Gate-Array mit einem Mikroprozessor zusammenarbeiten, um eines der hier beschriebenen Verfahren durchzuführen. Im Allgemeinen werden die Verfahren vorzugsweise von einem beliebigen Hardware-Gerät durchgeführt

Obwohl einige Aspekte der vorliegenden Offenbarung als Merkmale im Zusammenhang einer Vorrichtung beschrieben wurden, ist es klar, dass eine solche Beschreibung ebenfalls als eine Beschreibung entsprechender Verfahrensmerkmale betrachtet werden kann. Obwohl einige Aspekte als Merkmale im Zusammenhang mit einem Verfahren beschrieben wurden, ist klar, dass eine solche Beschreibung auch als eine Beschreibung entsprechender Merkmale einer Vorrichtung bzw. der Funktionalität einer Vorrichtung betrachtet werden können. Einige oder alle der Verfahrensschritte können durch einen Hardware-Apparat (oder unter Verwendung eines Hardware-Apparats), wie zum Beispiel einen Mikroprozessor, einen programmierbaren Computer oder einer elektronischen Schaltung durchgeführt werden. Bei einigen Ausführungsbeispielen können einige oder mehrere der Verfahrensschritte durch einen solchen Apparat ausgeführt werden. Je nach bestimmten Implementierungsanforderungen können Ausführungsbeispiele der Erfindung in Hardware oder in Software oder zumindest teilweise in Hardware oder zumindest teilweise in Software implementiert sein.

In der vorhergehenden detaillierten Beschreibung wurden teilweise verschiedene Merkmale in Beispielen zusammen gruppiert, um die Offenbarung zu rationalisieren. Diese Art der Offenbarung soll nicht als die Absicht interpretiert werden, dass die beanspruchten Beispiele mehr Merkmale aufweisen als ausdrücklich in jedem Anspruch angegeben sind. Vielmehr kann, wie die folgenden Ansprüche wiedergeben, der Gegenstand in weniger als allen Merkmalen eines einzelnen offenbarten Beispiels liegen. Folglich werden die folgenden Ansprüche hiermit in die detaillierte Beschreibung aufgenommen, wobei jeder Anspruch als ein eigenes separates Beispiel stehen kann. Während jeder Anspruch als ein eigenes separates Beispiel stehen kann, sei angemerkt, dass, obwohl sich abhängige Ansprüche in den Ansprüchen auf eine spezifische Kombination mit einem oder mehreren anderen Ansprüchen zurückbeziehen, andere Beispiele auch eine Kombination von abhängigen Ansprüchen mit dem Gegenstand jedes anderen abhängigen Anspruchs oder einer Kombination jedes Merkmals mit anderen abhängigen oder unabhängigen Ansprüchen umfassen. Solche Kombinationen seien umfasst, es sei denn es ist ausgeführt, dass eine spezifische Kombination nicht beabsichtigt ist. Ferner ist beabsichtigt, dass auch eine Kombination von Merkmalen eines Anspruchs mit jedem anderen unabhängigen Anspruch umfasst ist, selbst wenn dieser Anspruch nicht direkt abhängig von dem unabhängigen Anspruch ist.

Obwohl spezifische Ausführungsbeispiele hierin dargestellt und beschrieben wurden, wird einem Fachmann offensichtlich sein, dass eine Vielzahl von alternativen und/oder äquivalenten Implementierungen für die spezifischen dort gezeigten und dargestellten Ausführungsbeispiele ersetzt werden können, ohne von dem Gegenstand der vorliegenden Anmeldung abzuweichen. Dieser Anmeldungstext soll alle Adaptionen und Variationen der hierin beschriebenen und erörterten spezifischen Ausführungsbeispiele abdecken. Daher ist der vorliegende Anmeldungsgegenstand lediglich durch den Wortlaut der Ansprüche und den äquivalenten Ausführungsformen derselben begrenzt.

### Literaturverzeichnis

[1] M. Cheng, J. Hang und J. Zhang, "Overview of fault diagnosis theory and method for permanent magnet machine," Chinese Journal of Electrical Engineering, Dez. 2015.
[2] T. Orlowska-Kowalska, M. Wolkiewicz und P. Pietrzak, "Fault Diagnosis and Fault-Tolerant Control of PMSM Drives-State of the Art and Future Challenges," IEEE Access, Juni 2022.
[3] C. Bouchareb und M.-S. Nait-said, "PMSM model with phase-to-phase short-circuit and diagnosis by ESA and EPVA," Advances in Electrical and Electronic Engineering, Dez. 2016.
[4] K. Taraka, "Pyro-Fuse Circuit". US20190123542A1, Juni 2018.
[5] K. Takafumi, "Interruption control device". WO2023242988A1, Dec. 2025.

## Patentansprüche

1. Fehlererkennungsanordnung (100) für ein elektrisches Gleichspannungsnetzwerk (205), das ein erstes und ein zweites Teilsystem (210, 220) aufweist, mit folgenden Merkmalen:
einer Mehrzahl von Sensorelementen (112 - 118, 122 - 128) zum Bereitstellen einer Mehrzahl von Sensorsignalen (S₁₁₂-S₁₁₈ und S₁₂₂-S₁₂₈), wobei die Sensorsignale zumindest ein erstes Stromsensorsignal (S₁₁₂) basierend auf einem Eingangsstrom (S₂₁₀) des ersten Teilsystems (210), ein erstes Spannungssensorsignal (S₁₁₄) basierend auf einer Eingangsspannung (S₂₁₂) des ersten Teilsystems (210), ein zweites Stromsensorsignal (S₁₂₂) basierend auf einem Eingangsstrom (S₂₂₆) des zweiten Teilsystems (220) und ein zweites Spannungssensorsignal (S₁₂₄) basierend auf einer Eingangsspannung (S₂₂₂) des zweiten Teilsystems (220) aufweisen, und
wobei die Fehlererkennungsanordnung (100) ausgebildet ist, um ein erstes Fehlererkennungssignal (F1) auszugeben, das einen elektrischen Fehlerzustand in dem ersten Teilsystem (210) angibt, falls das erste Stromsensorsignal (S₁₁₂) einen ersten oberen Fehlerstromgrenzwert überschreitet und falls ferner (zumindest) eine der folgenden Bedingungen erfüllt ist:
- das erste Spannungssensorsignal (S₁₁₄) unterschreitet einen ersten Spannungsgrenzwert, oder
- der Gradient des ersten Spannungssensorsignals (S₁₁₄) unterschreitet einen ersten negativen Gradienten-Grenzwert, und
wobei die Fehlererkennungsanordnung (100) ferner ausgebildet ist, um ein zweites Fehlererkennungssignal (F2) auszugeben, das einen elektrischen Fehlerzustand in dem zweiten Teilsystem (220) angibt, falls das zweite Stromsensorsignal (S₁₂₂) einen zweiten oberen Fehlerstromgrenzwert überschreitet und falls ferner eine der folgenden Bedingungen erfüllt ist:
- das zweite Spannungssensorsignal (S₁₂₄) unterschreitet einen zweiten Spannungsgrenzwert, oder
- der Gradient des zweiten Spannungssensorsignals (S₁₂₄) unterschreitet einen zweiten negativen Gradienten-Grenzwert.

2. Fehlererkennungsanordnung nach Anspruch 1, wobei die Sensorelemente ausgebildet sind, um das erste Stromsensorsignal und das erste Spannungssensorsignal und ferner das zweite Stromsensorsignal und das zweite Spannungssensorsignal zeitsynchron zueinander bereitzustellen, oder
wobei die Fehlererkennungsanordnung ausgebildet ist, um das erste Stromsensorsignal und das erste Spannungssensorsignal und ferner das zweite Stromsensorsignal und das zweite Spannungssensorsignal für eine zeitsynchrone Auswertung zeitlich abzugleichen oder deren Signalverläufe aufzubereiten.

3. Fehlererkennungsanordnung nach Anspruch 1 oder 2,
wobei die Fehlererkennungsanordnung ferner ausgebildet ist, um das erste Fehlererkennungssignal auszugeben, falls das erste Stromsensorsignal den ersten oberen Fehlerstromgrenzwert zumindest für eine vorgegebene Stromfehler-Zeitdauer überschreitet,
und
um das zweite Fehlererkennungssignal auszugeben, falls das zweite Stromsensorsignal den zweiten oberen Fehlerstromgrenzwert zumindest für eine vorgegebene Stromfehler-Zeitdauer überschreitet.

4. Fehlererkennungsanordnung nach einem der vorhergehenden Ansprüche, wobei die Mehrzahl von Sensorsignalen für die Fehlererkennungsanordnung analoge Sensorsignale sind, und
wobei die Fehlererkennungsanordnung als eine analoge Fehlererkennungsschaltung zur analogen Auswertung von analogen Sensorsignalen im Zeitbereich ausgebildet ist.

5. Fehlererkennungsanordnung nach einem der vorhergehenden Ansprüche, wobei die Sensorsignale ferner erste Phasenstromsensorsignale basierend auf Phasensignalen eines ersten Wechselrichters in dem ersten Teilsystem und zweite Phasenstromsensorsignale basierend auf Phasensignalen eines zweiten Wechselrichters in dem zweiten Teilsystem aufweisen, und
wobei die Fehlererkennungsanordnung ferner ausgebildet ist, um das erste Fehlererkennungssignal auszugeben, falls die Summe der Phasenströme gleich Null ist, und falls ferner (zumindest) eine der folgenden Bedingungen erfüllt ist:
- zumindest eines der ersten Phasenstromsensorsignale überschreitet einen ersten oberen Phasenfehlerstromgrenzwert, oder
- zumindest eines der ersten Phasenstromsensorsignale unterschreitet einen ersten unteren Phasenfehlerstromgrenzwert
und
wobei die Fehlererkennungsanordnung ferner ausgebildet ist, um das zweite Fehlererkennungssignal auszugeben, falls die Summe der Phasenströme gleich Null ist, und falls ferner (zumindest) eine der folgenden Bedingungen erfüllt ist:
- zumindest eines der zweiten Phasenstromsensorsignale überschreitet einen zweiten oberen Phasenfehlerstromgrenzwert, oder
- zumindest eines der zweiten Phasenstromsensorsignale unterschreitet einen zweiten unteren Phasenfehlerstromgrenzwert.

6. Fehlererkennungsanordnung nach einem der vorhergehenden Ansprüche, wobei die Sensorsignale ferner ein erstes Fehlerstromsensorsignal einer ersten Treiberschaltungsanordnung für den ersten Wechselrichter in dem ersten Teilsystem und ein zweites Fehlerstromsensorsignal einer zweiten Treiberschaltungsanordnung für den zweiten Wechselrichter in dem zweiten Teilsystem aufweisen, und
wobei die Fehlererkennungsanordnung ferner ausgebildet ist, um das erste Fehlererkennungssignal auszugeben, falls das erste Fehlerstromsensorsignal einen Fehlerstromzustand der ersten Treiberschaltungsanordnung anzeigt,
und
um das zweite Fehlererkennungssignal auszugeben, falls das zweite Fehlerstromsensorsignal einen Fehlerstromzustand der zweiten Treiberschaltungsanordnung anzeigt.

7. Fehlererkennungsanordnung nach einem der vorhergehenden Ansprüche, wobei das erste Teilsystem einen ersten elektrischen Gleichspannungszwischenkreis und das zweite Teilsystem einen zweiten elektrischen Gleichspannungszwischenkreis aufweist, und wobei das erste Teilsystem einen ersten mehrphasigen Wechselrichter und das zweite Teilsystem einen zweiten mehrphasigen Wechselrichter aufweist.

8. Fehlererkennungsanordnung nach Anspruch 9, wobei das erste Stromsensorsignal auf einem Eingangsgleichstrom des ersten mehrphasigen Wechselrichters basiert, wobei das zweite Stromsensorsignal auf einem Eingangsgleichstrom des zweiten mehrphasigen Wechselrichters basiert, wobei das erste Spannungssensorsignal auf einer Zwischenkreisspannung am Eingang des ersten mehrphasigen Wechselrichters basiert, und wobei das zweite Spannungssensorsignal auf einer Zwischenkreisspannung am Eingang des zweiten mehrphasigen Wechselrichters basiert.

9. Fehlererkennungsanordnung nach einem der Ansprüche 5 bis 8,
wobei der erste Wechselrichter ausgebildet ist, um eine Mehrzahl von ersten Phasensignalen bereitzustellen, ferner mit folgenden Merkmalen:
- einer Mehrzahl von ersten Phasenstromsensoren zum Bereitstellen einer Mehrzahl von ersten Phasenstromsensorsignalen basierend auf den Phasensignalen des ersten Wechselrichters, und
wobei der zweite Wechselrichter ausgebildet ist, um eine Mehrzahl von zweiten Phasensignalen bereitzustellen, ferner mit folgenden Merkmalen:
- einer Mehrzahl von zweiten Phasenstromsensoren zum Bereitstellen einer Mehrzahl von zweiten Phasenstromsensorsignalen basierend auf den Phasensignalen des zweiten Wechselrichters

10. Fehlererkennungsanordnung nach einem der Ansprüche 5 bis 9, wobei das erste Teilsystem ferner eine erste Treiberschaltungsanordnung zur Ansteuern des ersten mehrphasigen Wechselrichters und das zweite Teilsystem ferner eine zweite Treiberschaltungsanordnung zur Ansteuern des zweiten mehrphasigen Wechselrichters aufweist,
wobei die erste Treiberschaltungsanordnung einen ersten Fehlerstromsensor zum Bereitstellen eines ersten Fehlerstromsensorsignals aufweist, falls die erste Treiberschaltungsanordnung einen Fehlerzustand aufweist, und
wobei die zweite Treiberschaltungsanordnung einen zweiten Fehlerstromsensor zum Bereitstellen eines zweiten Fehlerstromsensorsignals aufweist, falls die zweite Treiberschaltungsanordnung einen Fehlerzustand aufweist.

11. Fehlererkennungsanordnung nach einem der vorhergehenden Ansprüche, wobei die Fehlererkennungsanordnung eine erste und eine zweite Fehlererkennungsvorrichtung aufweist, wobei die erste Fehlererkennungsvorrichtung dem ersten Teilsystem und die zweite Fehlererkennungsvorrichtung dem zweiten Teilsystem zugeordnet ist,
wobei die Mehrzahl von Sensorelementen ausgebildet sind, um die Mehrzahl von Sensorsignalen für die erste und die zweite Fehlererkennungsvorrichtung bereitzustellen,
wobei die erste Fehlererkennungsvorrichtung ausgebildet ist, um das erste Fehlererkennungssignal auszugeben, das den elektrischen Fehlerzustand in dem ersten Teilsystem angibt, und
wobei die zweite Fehlererkennungsvorrichtung ausgebildet ist, um das zweite Fehlererkennungssignal auszugeben, das den elektrischen Fehlerzustand in dem zweiten Teilsystem angibt.

12. Fehlererkennungsanordnung nach Anspruch 11, wobei das elektrische Gleichspannungsnetzwerk eine elektrische Verteilerschaltung mit dem ersten und zweiten Teilsystem aufweist, und wobei die erste Fehlererkennungsvorrichtung in dem ersten Teilsystem der elektrischen Verteilerschaltung und die zweite Fehlererkennungsvorrichtung in dem zweiten Teilsystem der elektrischen Verteilerschaltung innerhalb des elektrischen Gleichspannungsnetzwerks angeordnet ist.

13. Fehlererkennungsanordnung nach einem der vorherigen Ansprüche, wobei die Fehlererkennungsanordnung ferner ausgebildet ist, um ein drittes Fehlererkennungssignal auszugeben, das einen weiteren elektrischen Fehlerzustand in dem ersten Teilsystem angibt,
falls das erste Stromsensorsignal einen ersten oberen Fehlerstromgrenzwert überschreitet und die Summe der ersten Phasenströme ungleich Null ist,
**oder**
falls das erste Stromsensorsignal einen ersten unteren Fehlerstromgrenzwert unterschreitet und die Summe der ersten Phasenströme ungleich Null ist, und falls ferner eine der folgenden Bedingungen erfüllt ist:
- das erste Spannungssensorsignal unterschreitet einen ersten Spannungsgrenzwert,
- der Gradient des ersten Spannungssensorsignals unterschreitet einen zweiten negativen Gradienten-Grenzwert,
- zumindest eines der ersten Phasenstromsensorsignale überschreitet einen ersten oberen Phasenfehlerstromgrenzwert,
- zumindest eines der ersten Phasenstromsensorsignale unterschreitet einen ersten unteren Phasenfehlerstromgrenzwert, oder
- das erste Überstromsensorsignal zeigt einen Überstromzustand der ersten Treiberschaltungsanordnung an,
und
wobei die Fehlererkennungsanordnung ferner ausgebildet ist, um ein viertes Fehlererkennungssignal auszugeben, das einen weiteren elektrischen Fehlerzustand in dem zweiten Teilsystem angibt,
falls das zweite Stromsensorsignal einen zweiten oberen Fehlerstromgrenzwert überschreitet und die Summe der zweiten Phasenströme ungleich Null ist,
**oder**
falls das zweite Stromsensorsignal einen zweiten unteren Fehlerstromgrenzwert unterschreitet und die Summe der zweiten Phasenströme ungleich Null ist, und falls ferner eine der folgenden Bedingungen erfüllt ist:
- das zweite Spannungssensorsignal unterschreitet einen zweiten Spannungsgrenzwert,
- der Gradient des zweiten Spannungssensorsignals unterschreitet einen zweiten negativen Gradienten-Grenzwert,
- zumindest eines der zweiten Phasenstromsensorsignale überschreitet einen zweiten oberen Phasenfehlerstromgrenzwert,
- zumindest eines der zweiten Phasenstromsensorsignale unterschreitet einen zweiten unteren Phasenfehlerstromgrenzwert, oder
- das zweite Überstromsensorsignal zeigt einen Überstromzustand der zweiten Treiberschaltungsanordnung an.

14. Fehlererkennungsanordnung nach Anspruch 13, wobei die Fehlererkennungsanordnung eine dritte und eine vierte Fehlererkennungsvorrichtung aufweist,
wobei die dritte Fehlererkennungsvorrichtung dem ersten Teilsystem zugeordnet ist und ausgebildet ist, um das dritte Fehlererkennungssignal auszugeben, das den weiteren elektrischen Fehlerzustand in dem ersten Teilsystem angibt, und
wobei die vierte Fehlererkennungsvorrichtung dem zweiten Teilsystem zugeordnet ist und ausgebildet ist, um das vierte Fehlererkennungssignal auszugeben, das den weiteren elektrischen Fehlerzustand in dem zweiten Teilsystem angibt.

15. Fehlererkennungsanordnung nach einem der vorherigen Ansprüche,
wobei das elektrische Gleichspannungsnetzwerk eine erste Trennanordnung aufweist, die ausgebildet ist, um bei Ausgabe des ersten oder dritten Fehlererkennungssignals das erste Teilsystem elektrisch von dem elektrischen Gleichspannungsnetzwerk zu trennen, und
wobei das elektrische Gleichspannungsnetzwerk eine zweite Trennanordnung aufweist, die ausgebildet ist, um bei Ausgabe des zweiten oder vierten Fehlererkennungssignals das zweite Teilsystem elektrisch von dem elektrischen Gleichspannungsnetzwerk zu trennen.

16. Verfahren (300) zur Fehlererkennung in einem elektrischem Gleichspannungsnetzwerk, das ein erstes und ein zweites Teilsystem aufweist, mit folgenden Schritten:
Bereitstellen (310) einer Mehrzahl von Sensorsignalen, wobei die Sensorsignale zumindest ein erstes Stromsensorsignal basierend auf einem Eingangsstrom des ersten Teilsystems, ein erstes Spannungssensorsignal basierend auf einer Eingangsspannung des ersten Teilsystems, ein zweites Stromsensorsignal basierend auf einem Eingangsstrom des zweiten Teilsystems und ein zweites Spannungssensorsignal basierend auf einer Eingangsspannung des zweiten Teilsystems aufweisen,
Ausgeben (320) eines ersten Fehlererkennungssignals, das einen elektrischen Fehlerzustand in dem ersten Teilsystem angibt, falls das erste Stromsensorsignal einen ersten oberen Fehlerstromgrenzwert überschreitet und falls ferner (zumindest) eine der folgenden Bedingungen erfüllt ist:
- das erste Spannungssensorsignal unterschreitet einen ersten Spannungsgrenzwert, oder
- der Gradient des ersten Spannungssensorsignals unterschreitet einen ersten negativen Gradienten-Grenzwert, und
Ausgeben (330) eines zweiten Fehlererkennungssignals, das einen elektrischen Fehlerzustand in dem zweiten Teilsystem angibt, falls das zweite Stromsensorsignal einen zweiten oberen Fehlerstromgrenzwert überschreitet und falls ferner (zumindest) eine der folgenden Bedingungen erfüllt ist:
- das zweite Spannungssensorsignal unterschreitet einen zweiten Spannungsgrenzwert, oder
- der Gradient des zweiten Spannungssensorsignals unterschreitet einen zweiten negativen Gradienten-Grenzwert.

17. Verfahren nach Anspruch 16, ferner mit folgendem Schritt:
zeitliches Abgleichen oder Aufbereiten des ersten Stromsensorsignals und des ersten Spannungssensorsignal und ferner des zweiten Stromsensorsignal und des zweiten Spannungssensorsignal für eine zeitsynchrone Auswertung der Signalverläufe.

18. Verfahren nach Anspruch 16 oder 17, ferner mit folgenden Schritten:
Ausgeben des ersten Fehlererkennungssignals, falls das erste Stromsensorsignal den ersten oberen Fehlerstromgrenzwert zumindest für eine vorgegebene Stromfehler-Zeitdauer überschreitet,
und
Ausgeben des zweiten Fehlererkennungssignals, falls das zweite Stromsensorsignal den zweiten oberen Fehlerstromgrenzwert zumindest für eine vorgegebene Stromfehler-Zeitdauer überschreitet.

19. Verfahren nach einem der Ansprüche 16 bis 18, wobei die Sensorsignale ferner erste Phasenstromsensorsignale basierend auf Phasensignalen eines ersten Wechselrichters in dem ersten Teilsystem und zweite Phasenstromsensorsignale basierend auf Phasensignalen eines zweiten Wechselrichters in dem zweiten Teilsystem aufweisen, ferner mit folgenden Schritten:
Ausgeben des ersten Fehlererkennungssignals, falls die Summe der Phasenströme gleich Null ist, und falls ferner (zumindest) eine der folgenden Bedingungen erfüllt ist:
- zumindest eines der ersten Phasenstromsensorsignale überschreitet einen ersten oberen Phasenfehlerstromgrenzwert, oder
- zumindest eines der ersten Phasenstromsensorsignale unterschreitet einen ersten unteren Phasenfehlerstromgrenzwert
und
Ausgeben des zweiten Fehlererkennungssignals, falls die Summe der Phasenströme gleich Null ist, und falls ferner (zumindest) eine der folgenden Bedingungen erfüllt ist:
- zumindest eines der zweiten Phasenstromsensorsignale überschreitet einen zweiten oberen Phasenfehlerstromgrenzwert, oder
- zumindest eines der zweiten Phasenstromsensorsignale unterschreitet einen zweiten unteren Phasenfehlerstromgrenzwert.

20. Verfahren nach einem der Ansprüche 16 bis 19, wobei der erste Wechselrichter ausgebildet ist, um eine Mehrzahl von ersten Phasensignalen bereitzustellen, und wobei der zweite Wechselrichter ausgebildet ist, um eine Mehrzahl von zweiten Phasensignalen bereitzustellen, ferner mit folgenden Schritten:
- Bereitstellen einer Mehrzahl von ersten Phasenstromsensorsignalen (einer Mehrzahl von ersten Phasenstromsensoren) basierend auf den Phasensignalen des ersten Wechselrichters, und
- Bereitstellen einer Mehrzahl von zweiten Phasenstromsensoren (mit einer Mehrzahl von zweiten Phasenstromsensorsignalen) basierend auf den Phasensignalen des zweiten Wechselrichters

21. Verfahren nach einem der Ansprüche 16 bis 20, mit folgenden Schritten:
Ausgeben eines dritten Fehlererkennungssignals, das einen weiteren elektrischen Fehlerzustand in dem ersten Teilsystem angibt,
falls das erste Stromsensorsignal einen ersten oberen Fehlerstromgrenzwert überschreitet und die Summe der ersten Phasenströme ungleich Null ist,
**oder**
falls das erste Stromsensorsignal einen ersten unteren Fehlerstromgrenzwert unterschreitet und die Summe der ersten Phasenströme ungleich Null ist, und falls ferner eine der folgenden Bedingungen erfüllt ist:
- das erste Spannungssensorsignal unterschreitet einen ersten Spannungsgrenzwert,
- der Gradient des ersten Spannungssensorsignals unterschreitet einen zweiten negativen Gradienten-Grenzwert,
- zumindest eines der ersten Phasenstromsensorsignale überschreitet einen ersten oberen Phasenfehlerstromgrenzwert,
- zumindest eines der ersten Phasenstromsensorsignale unterschreitet einen ersten unteren Phasenfehlerstromgrenzwert, oder
- das erste Überstromsensorsignal zeigt einen Überstromzustand der ersten Treiberschaltungsanordnung an,
und
Ausgeben eines vierten Fehlererkennungssignals, das einen weiteren elektrischen Fehlerzustand in dem zweiten Teilsystem angibt,
falls das zweite Stromsensorsignal einen zweiten oberen Fehlerstromgrenzwert überschreitet und die Summe der zweiten Phasenströme ungleich Null ist,
**oder**
falls das zweite Stromsensorsignal einen zweiten unteren Fehlerstromgrenzwert unterschreitet und die Summe der zweiten Phasenströme ungleich Null ist, und falls ferner eine der folgenden Bedingungen erfüllt ist:
- das zweite Spannungssensorsignal unterschreitet einen zweiten Spannungsgrenzwert,
- der Gradient des zweiten Spannungssensorsignals unterschreitet einen zweiten negativen Gradienten-Grenzwert,
- zumindest eines der zweiten Phasenstromsensorsignale überschreitet einen zweiten oberen Phasenfehlerstromgrenzwert,
- zumindest eines der zweiten Phasenstromsensorsignale unterschreitet einen zweiten unteren Phasenfehlerstromgrenzwert, oder
- das zweite Überstromsensorsignal zeigt einen Überstromzustand der zweiten Treiberschaltungsanordnung an.

22. Verfahren nach einem der Ansprüche 16 bis 21, wobei das elektrische Gleichspannungsnetzwerk eine erste und zweite Trennanordnung aufweist, mit folgenden Schritten:
Trennen des ersten Teilsystems von dem elektrischen Gleichspannungsnetzwerk bei Ausgabe des ersten oder dritten Fehlererkennungssignals, und
Trennen des zweiten Teilsystems von dem elektrischen Gleichspannungsnetzwerk bei Ausgabe des zweiten oder vierten Fehlererkennungssignals.
